(19) Europäisches Patentamt
European Patent Office
Office européen des brevets

(11) EP 4 108 700 A1

(12) EUROPEAN PATENT APPLICATION

(43) Date of publication:
**28.12.2022 Bulletin 2022/52**

(21) Application number: **21181835.6**

(22) Date of filing: **25.06.2021**

(51) International Patent Classification (IPC):
***C08G 61/12*** *(2006.01)* ***C08K 5/00*** *(2006.01)*
***C08L 65/00*** *(2006.01)* ***C09K 11/06*** *(2006.01)*
***G01N 27/327*** *(2006.01)* ***H01B 1/00*** *(2006.01)*
***H01L 51/00*** *(2006.01)* ***H05K 3/00*** *(2006.01)*

(52) Cooperative Patent Classification (CPC):
**C08G 61/126; C08L 65/00; H01B 1/127; H01L 51/0007; H01L 51/0037; H05K 3/00;**
C08G 2261/11; C08G 2261/1424; C08G 2261/3223; C08G 2261/43; C08G 2261/51; C08G 2261/794

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Heraeus Deutschland GmbH & Co. KG**
**63450 Hanau (DE)**

(72) Inventors:
- **Sauer-Stieglitz, Rüdiger**
  **51368 Leverkusen (DE)**
- **Lövenich, Wilfried**
  **51368 Leverkusen (DE)**
- **Viehmann, Philipp**
  **51368 Leverkusen (DE)**

(74) Representative: **Herzog IP Patentanwalts GmbH**
**Steinstraße 16-18**
**40212 Düsseldorf (DE)**

# (54) CURABLE CONDUCTIVE COMPOSITIONS

(57) The present invention relates to a composition comprising
i) at least one polythiophene selected from the group consisting of
- a polythiophene comprising monomer units of structure (I)

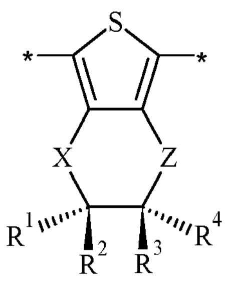

(I)

in which
*
indicates the bond to the neighboring monomer units,
X,Z
represent O or S,
$R^1$-$R^4$
independently from each other represent a hydrogen atom or an organic residue R, with the proviso that at least one of residues $R^1$ to $R^4$ represents an organic residue R;
- a polythiophene which is characterized by its compatibility in PGME (1-methoxypropan-2-ol), demonstrated by an RF-value of at least 0.8;

iii) at least one ethylenically unsaturated compound;
iv) at least one organic solvent;
v) at least one radical initiator.

The present invention also relates to a process for preparing a layer structure, to a layer structure obtainable by this process, to a layer structure, to an electronic component and to the use of composition according to the present invention.

Fig. 1

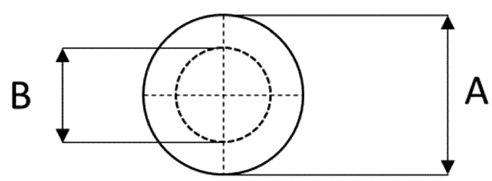


EP 4 108 700 A1

## Description

The present invention relates to a curable composition comprising at least one polythiophene and at least one ethylenically unsaturated compound that is polymerizable in a radical chain reaction. The present invention also relates to a process for preparing a layer structure, to a layer structure obtainable by this process, to a layer structure, to an electronic component and to the use of composition according to the present invention.

Polythiophenes are widely used as intrinsically conductive polymers. In particular poly(3,4-ethylenedioxythiophene) (PEDOT) has found many industrial applications such as solid electrolyte capacitors, antistatic coatings, electroluminescent lamps, organic light emitting diodes, organic solar cells and many others. For a large number or these applications PEDOT is used as a polymer complex with polystyrene-sulfonic acid as counter-ion dispersed in water or mixtures of water and other solvents (also referred to as "PEDOT/PSS").

Efforts have been made to supply PEDOT in aprotic solvents in order to extend the range of applications. WO-A-2012/059215 A1 discloses the use of blockcopolymers as counter-ions rendering the dispersion soluble in organic, aprotic solvents. The solubility parameters of the block-copolymer dominate and limit the solubility properties of the resulting PEDOT complex. Hence the dispersion becomes unstable once solvents such as PGMEA or ethanol are added.

KR-A-100945056 describes the polymerization of 3,4-ethylenedioxythiophene in water in the presence of surfactants. Subsequently the solvent is removed and is replaced by organic solvents. Such a re-dispersing process, however, is expensive and undesirable.

McCullough et al. ("A Simple Method to Prepare Head-to-Tail Coupled, Regioregular Poly(3-alkylthiophenes) Using Grignard Metathesis"; Adv. Mater. 1999, 11, 250) describe the synthesis of regioregular copolymers that can be dispersed in a number of solvents. However, the coupling through metal-organic compounds is expensive and the resulting polymers show only limited conductivity. Hence their application is limited to hole-transport layers, where only conductivity through the layer is required.

WO 2021/063956 A1 discloses compositions comprising PEDOT-derivatives and monomeric anions as counter-ions that are based on organic solvents. When blended with inert polymers such as polyacrylates, the compositions are still characterized by a low sheet resistance. The disadvantage of such blends, however, can be seen in the fact that the hardness of conductive layers that are obtained using such a blend is still improvable, particularly if these blends are used for the formation of antistatic layers.

The object of the present invention was to overcome the disadvantages of the prior art relating to electrically conductive polymers that are dissolved or dispersed in organic solvents and that are based on thiophene-monomers.

Particularly, it was an object of the present invention to provide a composition comprising electrically conductive polymers that are based on thiophene-monomers and that are dissolved or dispersed in organic solvents, wherein the compositions allow the formation of electrically conductive layers that are not only highly conductive and highly transparent, but that are also characterized by a sufficiently high hardness, compared to similar conductive layers known from the prior art.

Furthermore, it was also an object of the present invention to provide a stable composition, preferably a storage-stable composition comprising electrically conductive polymers that are based on thiophene-monomers and that are dissolved or dispersed in organic solvents, wherein the by means of these compositions conductive layers can be prepared that are characterized by a particularly advantageous hardness. The term "storage-stable" as used herein preferably characterizes a composition that, after being stored for 15 day, more preferably for 30 days, in darkness does not show the formation of a precipitate.

A contribution to at least partly solving at least one, preferably more than one, of the above objects is made by the independent claims. The dependent claims provide preferred embodiments which contribute to at least partly solving at least one of the objects.

|1| A contribution to solving at least one of the objects according to the invention is made by a 1$^{st}$ embodiment of a composition, preferably a curable composition, even more preferably a composition that is curable if exposed to electromagnetic radiation, electron beams or heat, comprising

**i)** at least one polythiophene comprising monomer units of structure (I)

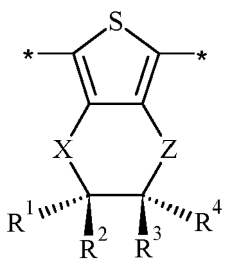

(I)

in which

* indicates the bond to the neighboring monomer units,

X,Z represent O or S,

$R^1$-$R^4$ independently from each other represent a hydrogen atom or an organic residue R, with the proviso that at least one of residues $R^1$ to $R^4$ represents an organic residue R;

**ii)** at least one organic compound carrying at least one acid group, preferably one or two sulfonic acid group(s), one or two sulfuric acid group(s), one or two phosphonic acid group(s) or one or two phosphoric acid group(s), or a salt of said organic compound, wherein the molecular weight of the organic compound or the salt thereof is less than 1,000 g/mol;

**iii)** at least one ethylenically unsaturated compound, preferably at least one ethylenically unsaturated compound that is polymerizable in a radical chain reaction;

**iv)** at least one organic solvent;

**v)** at least one radical initiator.

**|2|** A contribution to solving at least one of the objects according to the invention is also made by a 2nd embodiment of a composition, preferably a curable composition, even more preferably a composition that is curable if exposed to electromagnetic radiation, electron beams or heat, comprising

**i)** at least one polythiophene which is characterized by its compatibility in PGME (1-methoxypropan-2-ol), demonstrated by an RF-value of at least 0.6, preferably of at least 0.8 and more preferably of 1.0;

**ii)** optionally at least one organic compound carrying at least one acid group, preferably one or two sulfonic acid group(s), one or two sulfuric acid group(s), one or two phosphonic acid group(s) or one or two phosphoric acid group(s), or a salt of said organic compound, wherein the molecular weight of the organic compound or the salt thereof is less than 1,000 g/mol;

**iii)** at least one ethylenically unsaturated compound, preferably at least one ethylenically unsaturated compound that is polymerizable in a radical chain reaction;

**iv)** at least one organic solvent;

**v)** at least one radical initiator.

Surprisingly it was found that certain polythiophenes, for example those comprising monomer units of structure (I) as described above in which at least one of residues $R^1$ to $R^4$ represents a branched alkyl group or a branched ether group, are particularly suitable to be used as conductive polymers in curable compositions that are based on organic solvents and that comprise at least one ethylenically unsaturated compound that is polymerizable in a radical chain reaction. When such compositions are cured by polymerizing the polymerizable compound in the presence of the polythiophene for the formation of a polymer matrix into which the polythiophene is embedded, conductive layers can be

obtained that are not only highly conductive and highly transparent, but that are also characterized by a sufficiently high hardness. Moreover, it also has been observed that these compositions are characterized by an outstanding storage-stability.

**|3|** In a preferred embodiment of the 1st and the 2nd embodiment of the composition according to the present invention the composition is present in the form of a dispersion or solution (and wherein the organic solvent **iv)** thus serves as the dispersant or solvent), wherein polythiophene **i)** and the at least one organic compound **ii)** carrying at least one acid group (which is preferably present in the form of an anion) form a complex that - together with the at least one ethylenically unsaturated compound **iii)** - is dispersed or dissolved, preferably homogeneously dispersed or solved, in the organic solvent **iv).** Most preferably, the compositions according to the present invention are dispersions in which the complex of the polythiophene **i)** and the organic compound carrying at least one acid group **ii)** is homogeneously dispersed in the organic solvent **iv).** However, in the compositions according to the present invention the transitions between a "dispersion" and a "solution" can be fluid depending on the actual nature of the polythiophene **i),** the organic compound **ii)** carrying at least one acid group and the organic solvent **iv).** This preferred embodiment is a 3rd embodiment of the composition according to the present invention, that preferably depends on the 1st and the 2nd embodiment.

**|4|** In a further preferred embodiment of the 1st embodiment of the composition according to the present invention polythiophene **i)** is a homopolymer or copolymer comprising monomer units of structure (I) in which X and Z represent O, and wherein three of the residues selected from the group consisting of $R^1$, $R^2$, $R^3$ and $R^4$ represent a hydrogen atom and the remaining residue represents an ether group having the structural formula (Ia)

$$-(CR^7R^8)_n-O-R^9 \qquad \text{(Ia)}$$

wherein

- $R^7$ is H, a $C_1$-$C_{10}$-alkyl group, preferably a $C_1$-$C_5$-alkyl group, more preferably a methyl group, or a $C_1$-$C_{10}$-alkoxy group, preferably a $C_1$-$C_5$-alkoxy group, more preferably a methoxy group, wherein it is most preferred that $R^7$ is H;
- $R^8$ is H, a $C_1$-$C_{10}$-alkyl group, preferably a $C_1$-$C_5$-alkyl group, more preferably a methyl group, or a $C_1$-$C_{10}$-alkoxy group, preferably a $C_1$-$C_5$-alkoxy group, more preferably a methoxy group, wherein it is most preferred that $R^8$ is H;
- n is an integer in the range from 0 to 10, preferably in the range from 1 to 6 and more preferably in the range from 1 to 3, wherein it is most preferred that n is 1; and
- $R^9$ is an alkyl group, an alkoxy group, an aryl group, an ether group or an ester group, preferably a $C_1$-$C_{30}$ alkyl group, more preferably a $C_2$-$C_{25}$-alkyl group, even more preferably a $C_5$-$C_{20}$-alkyl group.

This preferred embodiment is a 4th embodiment of the composition according to the present invention, that preferably depends on the 1st or the 3rd embodiment.

|5| In a further preferred embodiment of the 1st embodiment of the composition according to the present invention polythiophene **i)** is a homopolymer or copolymer comprising monomer units of structure (I) in which X and Z represent O, and wherein three of the residues selected from the group consisting of $R^1$, $R^2$, $R^3$ and $R^4$ represent a hydrogen atom and the remaining residue represents a branched alkyl group or a branched ether group. In this context it is also particularly preferred that the remaining residue does not carry any sulfonic acid groups or salts of this group. This preferred embodiment is a 5th embodiment of the composition according to the present invention, that preferably depends on anyone of the 1st, the 3rd and the 4th embodiment. The term "branched ether group" as used herein preferably defines an ether group in which at least one of the two organic residues that are bonded to the oxygen atom are branched organic residues, i. e. organic residues comprising at least one carbon atom that is bonded via a single bond to at least three carbon atoms or to at least two carbon atoms and to the oxygen atom that is part of the ether group.

|6| In a further preferred embodiment of the 1st embodiment of the composition according to the present invention polythiophene **i)** is a homopolymer or copolymer comprising monomer units of structure (I) in which X and Z represent O, and wherein three of the residues selected from the group consisting of $R^1$, $R^2$, $R^3$ and $R^4$ represent a hydrogen atom and the remaining residue represents a branched alkyl group.

This preferred embodiment is a 6th embodiment of the composition according to the present invention, that preferably depends on the 5th embodiment. Suitable examples of monomer units of structure (Ia) carrying a branched alkyl group or more than one alkyl group comprise a compound selected from the group consisting of compounds (A), (B), (C) and (D):

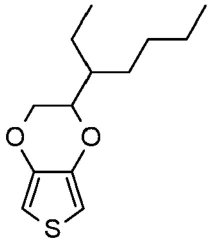
(A)

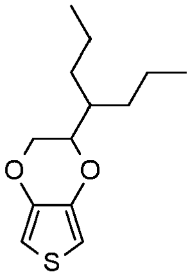
(B)

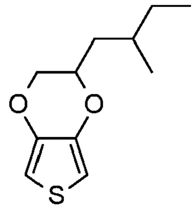
(C)

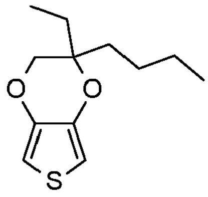
(D)

|7| In a further preferred embodiment of the 1st embodiment of the composition according to the present invention polythiophene **i)** is a homopolymer or copolymer comprising monomer units of structure (I) in which X and Z represent O, and wherein three of the residues selected from the group consisting of $R^1$, $R^2$, $R^3$ and $R^4$ represent a hydrogen atom and the remaining residue represents a branched ether group having the structural formula (Ic)

$-(CR^{10}R^{11})_n-O-R^{12}$ (IIc)

wherein

- $R^{10}$ is H, a $C_1$-$C_{10}$-alkyl group, preferably a $C_1$-$C_5$-alkyl group, more preferably a methyl group, or a $C_1$-$C_{10}$-alkoxy group, preferably a $C_1$-$C_5$-alkoxy group, more preferably a methoxy group, wherein it is most preferred that $R^{10}$ is H;
- $R^{11}$ is H, a $C_1$-$C_{10}$-alkyl group, preferably a $C_1$-$C_5$-alkyl group, more preferably a methyl group, or a $C_1$-$C_{10}$-alkoxy group, preferably a $C_1$-$C_5$-alkoxy group, more preferably a methoxy group, wherein it is most preferred that $R^{11}$ is H;
- n is an integer in the range from 0 to 10, preferably in the range from 1 to 6 and more preferably in the range from 1 to 3, wherein it is most preferred that n is 1; and
- $R^{12}$ is a branched organic residue, preferably a branched alkyl group or a branched arylalkyl group, more preferably a branched alkyl group or a branched arylalkyl group that do not carry an unsaturated C=C-bond in the alkyl chain, even more preferably an organic residue having formula (Id)

$-(CHR^{13})_m-R^{14}$ (Id)

wherein

- m is 1, 2 or 3,
- $R^{13}$ is H or a $C_1$-$C_{12}$ alkyl group, preferably a $C_2$-$C_{10}$ alkyl group and more preferably a $C_3$-$C_8$ alkyl group, even more preferably a butyl group, with the provisio that in only one of the m structural units $-CHR^{13}$-residue $R^{13}$ is a $C_1$-$C_{12}$ alkyl group;
- $R^{14}$ is a $C_1$-$C_{10}$-alkyl group, preferably a $C_2$-$C_6$-alkyl group, or a aryl group.

This preferred embodiment is a 7th embodiment of the composition according to the present invention, that preferably depends on the 5th embodiment. Suitable examples of such polythiophenes are homopolymers or copolymers comprising monomer units selected from the group consisting of compounds (E), (F) and (G):

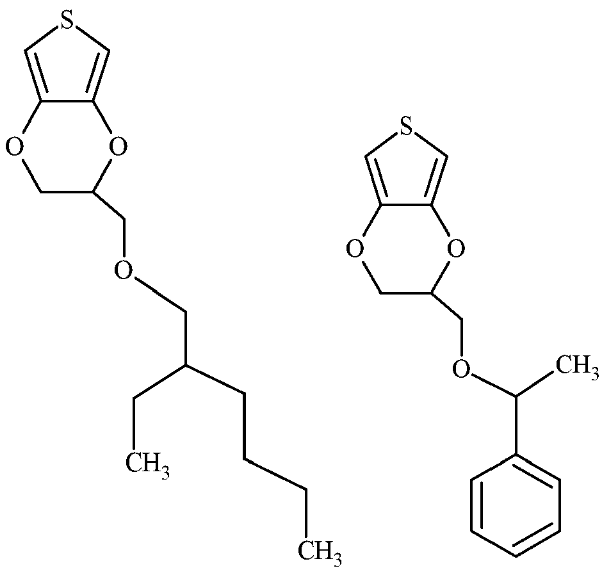

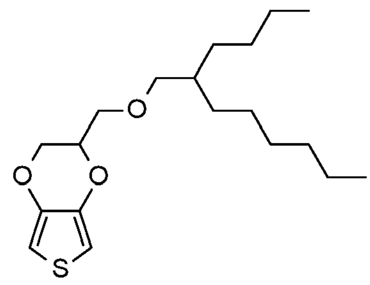

(E) (F) (G)

**|8|** In a further preferred embodiment of the $1^{st}$ embodiment of the composition according to the invention polythiophene **i)** is a copolymer of monomer units of structure (I) and at least one further thiophene monomer selected from the group consisting of 3,4-ethylenedioxythiophene, 2-ethyl-2,3-dihydrothieno[3,4-b]-1,4-dioxine, 2-propyl-2,3-dihydrothieno-[3,4-b]-1,4-dioxine 2-butyl-2,3-dihydro-thieno[3,4-b]-1,4-dioxine and 2-decyl-2,3-dihydrothieno[3,4-b][1,4]dioxine, wherein the copolymer comprises 5 to 95 % monomer units, preferably 10 to 80 % monomer units and more preferably 20 to 60 % monomer units of structure (I), in each case based on the total number of thiophene monomer units. This preferred embodiment is a $8^{th}$ embodiment of the composition according to the present invention, that preferably depends on anyone of the $1^{st}$ or the $3^{rd}$ to the $7^{th}$ embodiment. According to a particularly preferred variant of this preferred embodiment of the composition according to the present invention the at least one further thiophene monomer is a thiophene monomer selected from the group consisting of 2-ethyl-2,3-dihydrothieno[3,4-b]-1,4-dioxine, 2-propyl-2,3-dihydro-thieno-[3,4-b]-1,4-dioxine 2-butyl-2,3-dihydro-thieno[3,4-b]-1,4-dioxine and 2-decyl-2,3-dihydrothieno[3,4-b][1,4]dioxine, wherein the use of 2-butyl-2,3-dihydrothieno[3,4-b]-1,4-dioxine is particularly preferred.

|9| In a further preferred embodiment of the $1^{st}$ embodiment of the composition according to the invention polythiophene **i)** is characterized by its compatibility in PGME (1-methoxypropan-2-ol), demonstrated by an RF-value of at least 0.6, preferably of at least 0.8 and more preferably of 1.0. This preferred embodiment is a $9^{th}$ embodiment of the composition according to the present invention, that preferably depends on anyone of the $1^{st}$ or the $3^{rd}$ to the $8^{th}$ embodiment.

**|10|** In a preferred embodiment of the $2^{nd}$ embodiment of the composition according to the invention polythiophene **i)** is a characterized by a contact angle higher than 40, preferably higher than 50 and more preferably higher than 60. This preferred embodiment is a $10^{th}$ embodiment of the composition according to the present invention, that preferably depends on the $2^{nd}$ embodiment.

|11| In a further preferred embodiment of the $2^{nd}$ embodiment of the composition composition according to the invention polythiophene **i)** is a polythiophene comprising monomer units of structure (I)

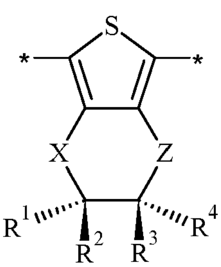

(I)

in which

- * indicates the bond to the neighboring monomer units,
- X,Z represent O or S,
- $R^1$-$R^4$ independently from each other represent a hydrogen atom or an organic residue R, with the proviso that at least one of residues $R^1$ to $R^4$ represents an organic residue R;

This preferred embodiment is a 11th embodiment of the composition according to the present invention, that preferably depends on the 2nd and the 10th embodiment.

**|12|** In a further preferred embodiment of the 1st and the 2nd embodiment of the composition according to the present invention the at least one organic compound **ii)** carrying at least one acid group is an organic compound carrying at least one inorganic acid group, preferably one or two inorganic acid group(s), wherein the inorganic acid group is a sulfonic acid group (-$SO_2OH$), a sulfuric acid group (-O-$SO_2OH$), a phosphonic acid group (-$PO(OH)_2$), a phosphoric acid group (-O-$PO(OH)_2$) or a salt thereof, preferably a sulfonic acid group (-$SO_2OH$) or a salt thereof. This preferred embodiment is a 12th embodiment of the composition according to the present invention, that preferably depends on anyone of the 1st to the 11th embodiment.

**|13|** In a further preferred embodiment of the 1st and the 2nd embodiment of the composition according to the present invention the organic compound **ii)** carrying at least one acid group is an anionic surfactant. This preferred embodiment is an 13th embodiment of the composition according to the present invention, that preferably depends on anyone of the 1st to the 12th embodiment.

|14| In a further preferred embodiment of the 1st and the 2nd embodiment of the composition according to the present invention the at least one organic compound **ii)** carrying at least one acid group is a monovalent sulfonic acid or a salt thereof. Suitable monovalent sulfonic acid are, for example, benzene sulfonic acid, toluene sulfonic acid, ethylbenzene sulfonic acid, dodecylbenzene sulfonic acid, methane sulfonic acid or trifluormethane sulfonic acid or mixtures or salts thereof, wherein the use of dodecylbenzene sulfonic acid is particularly preferred. The term *"dodecyl benzene sulfonic acid"* as used herein also encompassed mixtures of alkylbenzene sulfonic acids which, in addition to dodecylbenzene sulfonic acid, further comprises alkylbenzene sulfonic acids with alkyl chains that are longer or shorter than the dodecyl-group. This preferred embodiment is a 14th embodiment of the composition according to the present invention, that preferably depends on anyone of the 1st to the 13th embodiment.

|14| In a further preferred embodiment of the 1st and the 2nd embodiment of the composition according to the present invention the weight ratio of polythiophene **i)** to at least one organic compound **ii)** carrying at least one acid group in the composition is in the range from 1 : 30 to 1 : 0.1, preferably in the range from 1 : 20 to 1 : 0.2 and more preferably in the range from 1 : 5 to 1 : 0.5. This preferred embodiment is a 12th embodiment of the composition according to the present invention, that preferably depends on anyone of the 1st to the 11th embodiment.

|15| In a further preferred embodiment of the 1st and the 2nd embodiment of the composition according to the present invention the composition comprises the polythiophene **i)** and the organic compound **ii)** carrying at least one acid group in a total amount in the range from 0.01 to 10 wt.-%, more preferably in an amount in the range from 0.2 to 6 wt.-% and most preferably in an amount in the range from 0.5 to 4 wt.-%, for each range relative to the total solids content of the composition. This preferred embodiment is an 15th embodiment of the composition according to the present invention, that preferably depends on anyone of the 1st to the 14th embodiment.

|16| In a further preferred embodiment of the 1st and the 2nd embodiment of the composition according to the present invention the at least one ethylenically unsaturated compound **iii)** is a compound carrying one or more (alk)acrylic acid-groups, preferably one or more (meth)acrylic acid-groups, a compound carrying one or more allyl-groups, a compound carrying one or more vinyl-groups or a compound carrying a combination of at least two of these ethylenically unsaturated groups. This preferred embodiment is an 16th embodiment of the composition according to the present invention, that preferably depends on anyone of the 1st to the 15th embodiment. The term "(meth)acrylic acid", as used herein, refers to both, the acrylic acid-derivative as well as the methacrylic acid derivative of the corresponding compounds carrying the "(meth)acrylic acid-group".

|17| In a further preferred embodiment of the 1st and the 2nd embodiment of the composition according to the present invention the composition comprises the at least one ethylenically unsaturated compound **iii)** that is polymerizable in a radical chain reaction in an amount in the range from 30 to 99.99 wt.-%, more preferably in an amount in the range from 50 to 98 wt.-% and most preferably in an amount in the range from 80 to 95 wt.-%, in each case based on the solids content of the composition. This preferred embodiment is a 17th embodiment of the composition according to the present invention, that preferably depends on anyone of the 1st to the 16th embodiment.

|18| In a further preferred embodiment of the 1st and the 2nd embodiment of the composition according to the present invention the weight ratio of the total weight of polythiophene **i)** and organic compound **ii)** carrying at least one

acid group to the weight of the ethylenically unsaturated compound **iii)** is in the range from 0.1 : 99.99 to 1 : 10, preferably in the range from 0.2 : 99.8 to 5 : 95 and more preferably in the range from 0.5 : 99.5 to 4 : 96. This preferred embodiment is a 18$^{th}$ embodiment of the composition according to the present invention, that preferably depends on anyone of the 1$^{st}$ to the 17$^{th}$ embodiment.

|19| In a further preferred embodiment of the 1$^{st}$ and the 2$^{nd}$ embodiment of the composition according to the present invention the at least one organic solvent **iv)** is protic solvent. This preferred embodiment is a 19$^{th}$ embodiment of the composition according to the present invention, that preferably depends on anyone of the 1$^{st}$ to the 18$^{th}$ embodiment.

|20| In a further preferred embodiment of the 1$^{st}$ and the 2$^{nd}$ embodiment of the composition according to the present invention the organic solvent **iv)** is selected from the group consisting of aromatic hydrocarbons, ketones, esters, ethers, alcohols and mixtures thereof. This preferred embodiment is a 20$^{th}$ embodiment of the composition according to the present invention, that preferably depends on anyone of the 1$^{st}$ to the 19$^{th}$ embodiment.

|21| In a further preferred embodiment of the 1$^{st}$ and the 2$^{nd}$ embodiment of the composition according to the present invention the organic solvent **iv)** is selected from the group consisting of acetone, methyl ethyl ketone, methyl isobutyl ketone, toluene, xylene, anisole, methyl benzoate, ethyl benzoate, propyl benzoate, butyl benzoate, methyl acetate, ethyl acetate, propyl acetate, butyl acetate, octyl acetate, methyl propionate, ethyl propionate, propyl propionate, butyl propionate, 1-methoxy-2-propylacetat, 1-methoxy-2-propanol, butanol, 2-propanol, ethanol and mixtures thereof or mixtures of one or two of these aprotic solvents with one or two further solvents. This preferred embodiment is a 21$^{st}$ embodiment of the composition according to the present invention, that preferably depends on anyone of the 1$^{st}$ to the 20$^{th}$ embodiment. A particularly preferred solvent is 1-methoxy-2-propanol (PGME).

|22| In a further preferred embodiment of the 1$^{st}$ and the 2$^{nd}$ embodiment of the composition according to the present invention the at least one radical initiator is a photo-radical initiator capable of forming a radical upon irradiation with light, more preferably a UV-photo-radical initiator capable of forming a radical upon irradiation with UV-light.

This preferred embodiment is a 22$^{nd}$ embodiment of the composition according to the present invention, that preferably depends on anyone of the 1$^{st}$ to the 21$^{st}$ embodiment.

Suitable examples of the radical initiator v) include type 1-initiators, which generate radicals through decomposition of molecules due to differences in chemical structure or molecular binding energy, and type 2-initiators, which coexist with tertiary amines to induce hydrogen abstraction. Type 1-initiators may be selected from the group consisting of acetophenones, such as 4-phenoxy dichloroacetophenone, 4-t-butyl dichloroacetophenone, 4-t-butyl trichloroacetophenone, diethoxyacetophenone, 2-hydroxy-2-methyl-1-phenylpropan-1-one, 1-(4-isopropylphenyl)-2-hydroxy-2-methylpropan-1-one, 1-(4-dodecylphenyl)-2-hydroxy-2-methylpropan-1-one, 4-(2-hydroxyethoxy)-phenyl(2-hydroxy-2-propyl)ketone or 1-hydroxycyclohexylphenylketone, benzoins, such as benzoin, benzoin methyl ether, benzoin ethyl ether or benzyl dimethyl ketal, phosphine oxides and titanocene compounds. Type 2 initiators may be selected from the group consisting of benzophenones, such as benzophenone, benzoylbenzoic acid, benzoylbenzoic acid methyl ether, 4-phenylbenzophenone, hydroxybenzophenone, 4-benzoyl-4'-methyldiphenylsulfide or 3,'-methyl-4-methoxybenzophenone, and thioxanthone compounds, such as thioxanthone, 2-chlorothioxanthone, 2-methyl thioxanthone, 2,4-dimethyl thioxanthone or isopropyl thioxanthone. These photo-initiators may be used alone or in combinations of two or more thereof, and type 1- and type 2-photo initiators may be used in a mixture thereof.

|23| In a further preferred embodiment of the 1$^{st}$ and the 2$^{nd}$ embodiment of the composition according to the present invention the composition comprises the radical initiator **v)** in an amount in the range from 0.01 to 20 wt.-%, preferably in the range from 0.1 to 10 wt.-% and more preferably in the range from 0.5 to 5 wt.-%, in each case based on the solids content of the composition. This preferred embodiment is a 23$^{rd}$ embodiment of the composition according to the present invention, that preferably depends on anyone of the 1$^{st}$ to the 22$^{nd}$ embodiment.

|24| In a further preferred embodiment of the 1$^{st}$ and the 2$^{nd}$ embodiment of the composition according to the present invention the composition further comprises

> **vi)** at least one additive being different from components **i)** to **v),** preferably an additive selected from the group consisting of a UV stabilizer, a heat stabilizer, an antioxidant, a UV absorber, a conductivity-improving agent, an adhesion promoter, a polymeric binder or a combination of at least two of these additives.

This preferred embodiment is a 24$^{th}$ embodiment of the composition according to the present invention, that preferably depends on anyone of the 1$^{st}$ to the 23$^{rd}$ embodiment.

|25| In a further preferred embodiment of the 1$^{st}$ and the 2$^{nd}$ embodiment of the composition according to the present invention the composition comprises an additive **vi)** being different from components **i)** to **v)** in an amount in the range from 0.01 to 25 wt.-%, preferably in the range from 0.1 to 20 wt.-% and more preferably in the range from 1 to 10 wt.-%, in each case based on the solids content of the composition. This preferred embodiment is a 25$^{th}$ embodiment of the composition according to the present invention, that preferably depends on anyone of the 1$^{st}$ to the 24$^{th}$ embodiment.

|26| In a further preferred embodiment of the 1$^{st}$ and the 2$^{nd}$ embodiment of the composition according to the present invention the composition has a water content of less than 2 wt.-%, preferably of less than 1 wt.-% and even

more preferably of less than 0.5 wt.-%, in each case based on the total weight of the composition. This preferred embodiment is a 26th embodiment of the composition according to the present invention, that preferably depends on anyone of the 1st to the 25th embodiment.

|27| In a further preferred embodiment of the 1st and the 2nd embodiment of the composition according to the present invention the composition has an iron content of less than 10 ppm, preferably of less than 1 ppm and more preferably of less than 0.1 ppm, in each case based on the total weight of the composition. This preferred embodiment is a 27th embodiment of the composition according to the present invention, that preferably depends on anyone of the 1st to the 26th embodiment.

|28| In a further preferred embodiment of the 1st and the 2nd embodiment of the composition according to the present invention a conductive layer prepared with the composition has a sheet resistance of at most $1 \times 10^{10}$ Ohm/sq, preferably at most $5 \times 10^{9}$ Ohm/sq and more preferably of at most $1 \times 10^{8}$ Ohm/sq. This preferred embodiment is a 28th embodiment of the composition according to the present invention, that preferably depends on anyone of the 1st to the 27th embodiment.

|29| In a further preferred embodiment of the 1st and the 2nd embodiment of the composition according to the present invention a conductive layer prepared with the composition has a pencil hardness of at least 1 H, preferably of at least 2 H and more preferably of at least 3 H. This preferred embodiment is a 29th embodiment of the composition according to the present invention, that preferably depends on anyone of the 1st to the 28th embodiment.

|1| A contribution to solving at least one of the objects according to the invention is also made by a 1st embodiment of a process for the preparation of a layer structure, comprising the process steps of

**A)** provision of a substrate;

**B)** coating the substrate with a composition according to the present invention;

**C)** optionally at least partial removal of the organic solvent iv);

**D)** exposing the coated substrate (101) to electromagnetic radiation, preferably to UV-radiation, to electron beams, to heat or to a combination of at least two thereof, in order to cure the composition by polymerizing the at least one ethylenically unsaturated compound **iii)** in a radical chain reaction.

|2| In a preferred embodiment of the process according to the present invention the substrate provided in process step **A)** is selected from the group consisting of paper, polymers, glass or ceramic. For optical uses, the substrate is preferably transparent or light-transmitting. Transparent substrates can be made of glass, extremely thin glass (flexible glass) or plastics. Particularly suitable plastics are: polycarbonates, polyesters, such as e.g. PET and PEN (polyethylene terephthalate or polyethylene-naphthalene dicarboxylate), copolycarbonates, polysulphone, polyether sulphone (PES), polyimide, polyethylene, polypropylene or cyclic polyolefins or cyclic olefin copolymers (COC), hydrogenated styrene polymers or hydrogenated styrene copolymers. Rigid or flexible substrates can be used. This preferred embodiment is a 2nd embodiment of the process according to the present invention, that preferably depends on the 1st embodiment.

|3| In a further preferred embodiment of the process according to the present invention coating of the substrate with the composition according to the present invention in process step B) is accomplished by immersion, dipping, pouring, dripping on, spraying, misting on, knife coating, brushing or printing, for example ink-jet, screen or tampon printing. This preferred embodiment is a 3rd embodiment of the process according to the present invention, that preferably depends on the 1st or the 2nd embodiment.

A contribution to solving at least one of the objects according to the invention is also made by a layer structure, obtainable by the process according to the present invention. The layer structure preferably has a pencil hardness of at least 1 H, preferably of at least 2 H and more preferably of at least 2 H. Moreover, the layer structure preferably has a transmission (including the substrate) of at least 80 %, preferably at least 85 %, more preferably at least 87 % and most preferably at least 89 %.

|1| A contribution to solving at least one of the objects according to the invention is also made by a 1st embodiment of a layer structure, comprising

a) a substrate;

b) a conductive layer coated onto the substrate, wherein the conductive layer comprises

- at least one polythiophene comprising monomer units of structure (I)

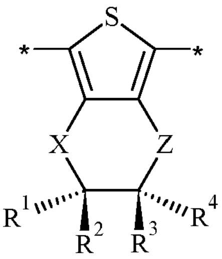

(I)

in which

| | |
|---|---|
| * | indicates the bond to the neighboring monomer units, |
| X,Z | represent O or S, |
| $R^1$-$R^4$ | independently from each other represent a hydrogen atom or an organic residue R, with the proviso that at least one of residues $R^1$ to $R^4$ represents an organic residue R; |

- at least one organic compound **ii)** carrying at least one acid group, preferably one or two sulfonic acid group(s), one or two sulfuric acid group(s), one or two phosphonic acid group(s) or one or two phosphoric acid group(s), or a salt of said organic compound, wherein the molecular weight of the organic compound or the salt thereof is less than 1,000 g/mol;

- a polymer matrix based on a polymerized ethylenically unsaturated compound **iii)** into which the at least one polythiophene is embedded;

wherein the conductive polymer layer has a pencil hardness of at least 1 H, preferably of at least 2 H and more preferably of at least 3 H.

|2| A contribution to solving at least one of the objects according to the invention is also made by a 2nd embodiment of a layer structure, comprising

a) a substrate;

b) a conductive layer coated onto the substrate, wherein the conductive layer comprises

- at least one polythiophene which is characterized by its compatibility in PGME (1-methoxypropan-2-ol), demonstrated by an RF-value of at least 0.6, preferably of at least 0.8 and more preferably of 1.0;

- optionally at least one organic compound **ii)** carrying at least one acid group, preferably one or two sulfonic acid group(s), one or two sulfuric acid group(s), one or two phosphonic acid group(s) or one or two phosphoric acid group(s), or a salt of said organic compound, wherein the molecular weight of the organic compound or the salt thereof is less than 1,000 g/mol;

- a polymer matrix based on a polymerized ethylenically unsaturated compound **iii)** into which the at least one polythiophene is embedded;

wherein the conductive polymer layer has a pencil hardness of at least 1 H, preferably of at least 2 H and more preferably of at least 3 H.

|3| In a preferred embodiment of the 1st embodiment of the layer structure according to the invention polythiophene **i)** is a homopolymer or copolymer comprising monomer units of structure (I) in which X and Z represent O, and wherein three of the residues selected from the group consisting of $R^1$, $R^2$, $R^3$ and $R^4$ represent a hydrogen atom and the remaining residue represents an ether group having the structural formula (Ia)

$$-(CR^7R^8)_n-O-R^9 \qquad \text{(Ia)}$$

wherein

- $R^7$ is H, a $C_1$-$C_{10}$-alkyl group, preferably a $C_1$-$C_5$-alkyl group, more preferably a methyl group, or a $C_1$-$C_{10}$-alkoxy group, preferably a $C_1$-$C_5$-alkoxy group, more preferably a methoxy group, wherein it is most preferred that $R^7$ is H;
- $R^8$ is H, a $C_1$-$C_{10}$-alkyl group, preferably a $C_1$-$C_5$-alkyl group, more preferably a methyl group, or a $C_1$-$C_{10}$-alkoxy group, preferably a $C_1$-$C_5$-alkoxy group, more preferably a methoxy group, wherein it is most preferred that $R^8$ is H;
- n is an integer in the range from 0 to 10, preferably in the range from 1 to 6 and more preferably in the range from 1 to 3, wherein it is most preferred that n is 1; and
- $R^9$ is an alkyl group, an alkoxy group, an aryl group, an ether group or an ester group, preferably a $C_1$-$C_{30}$ alkyl group, more preferably a $C_2$-$C_{25}$-alkyl group, even more preferably a $C_5$-$C_{20}$-alkyl group.

This preferred embodiment is a 3rd embodiment of the layer structure according to the present invention, that preferably depends on the 1st embodiment.

|4| In a further preferred embodiment of the 1st embodiment of the layer structure according to the invention polythiophene **i)** is a homopolymer or copolymer comprising monomer units of structure (I) in which X and Z represent O, and wherein three of the residues selected from the group consisting of $R^1$, $R^2$, $R^3$ and $R^4$ represent a hydrogen atom and the remaining residue represents a branched alkyl group or a branched ether group. In this context it is also particularly preferred that the remaining residue does not carry any sulfonic acid groups or salts of this group. This preferred embodiment is a 4th embodiment of the layer structure according to the present invention, that preferably depends on the 1st or the 3rd embodiment.

|5| In a further preferred embodiment of the 1st embodiment of the layer structure according to the invention polythiophene **i)** is a homopolymer or copolymer comprising monomer units of structure (I) in which X and Z represent O, and wherein three of the residues selected from the group consisting of $R^1$, $R^2$, $R^3$ and $R^4$ represent a hydrogen atom and the remaining residue represents a branched alkyl group.

This preferred embodiment is a 5th embodiment of the layer structure according to the present invention, that preferably depends on the 4th embodiment. Suitable examples of monomer units of structure (Ia) carrying a branched alkyl group or more than one alkyl group comprise a compound selected from the group consisting of compounds (A), (B), (C) and (D):

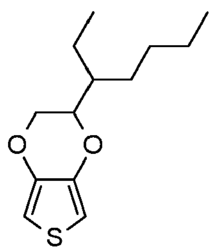
(A)

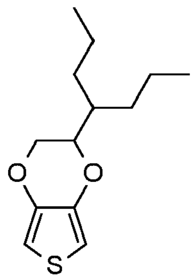
(B)

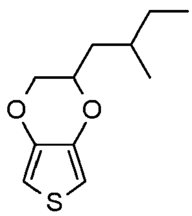
(C)

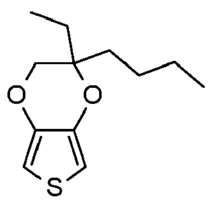
(D)

|6| In a further preferred embodiment of the 1st embodiment of the layer structure according to the invention polythiophene **i)** is a homopolymer or copolymer comprising monomer units of structure (I) in which X and Z represent O, and wherein three of the residues selected from the group consisting of $R^1$, $R^2$, $R^3$ and $R^4$ represent a hydrogen atom and the remaining residue represents a branched ether group having the structural formula (Ic)

$$-(CR^{10}R^{11})_n-O-R^{12} \qquad \text{(IIc)}$$

wherein

- $R^{10}$ is H, a $C_1$-$C_{10}$-alkyl group, preferably a $C_1$-$C_5$-alkyl group, more preferably a methyl group, or a $C_1$-$C_{10}$-alkoxy group, preferably a $C_1$-$C_5$-alkoxy group, more preferably a methoxy group, wherein it is most preferred that $R^{10}$ is H;
- $R^{11}$ is H, a $C_1$-$C_{10}$-alkyl group, preferably a $C_1$-$C_5$-alkyl group, more preferably a methyl group, or a $C_1$-$C_{10}$-alkoxy group, preferably a $C_1$-$C_5$-alkoxy group, more preferably a methoxy group, wherein it is most preferred that $R^{11}$ is H;
- n is an integer in the range from 0 to 10, preferably in the range from 1 to 6 and more preferably in the range from 1 to 3, wherein it is most preferred that n is 1; and
- $R^{12}$ is a branched organic residue, preferably a branched alkyl group or a branched arylalkyl group, more preferably a branched alkyl group or a branched arylalkyl group that do not carry an unsaturated C=C-bond in the alkyl

chain, even more preferably an organic residue having formula (Id)

$-(CHR^{13})_m-R^{14}$ (Id)

wherein

m is 1, 2 or 3,

$R^{13}$ is H or a $C_1$-$C_{12}$ alkyl group, preferably a $C_2$-$C_{10}$ alkyl group and more preferably a $C_3$-$C_8$ alkyl group, even more preferably a butyl group, with the provisio that in only one of the m structural units $-CHR^{13}$-residue $R^{13}$ is a $C_1$-$C_{12}$ alkyl group;

$R^{14}$ is a $C_1$-$C_{10}$-alkyl group, preferably a $C_2$-$C_6$-alkyl group, or a aryl group.

This preferred embodiment is a 6th embodiment of the layer structure according to the present invention, that preferably depends on the 4th embodiment. Suitable examples of such polythiophenes are homopolymers or copolymers comprising monomer units selected from the group consisting of compounds (E), (F) and (G):

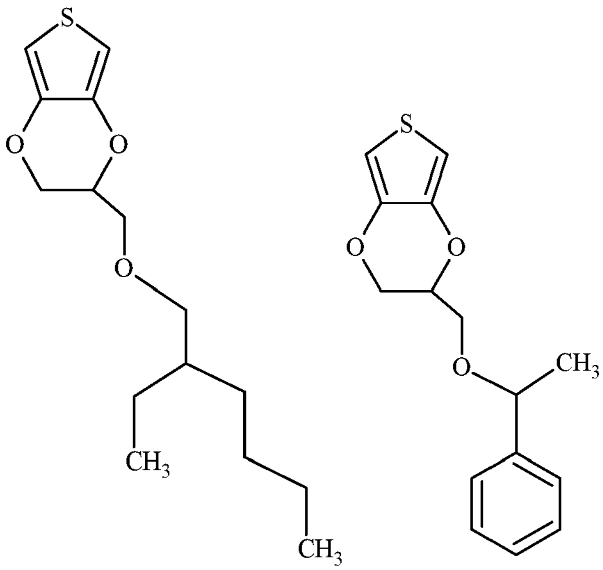
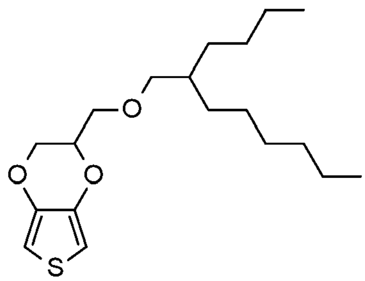

(E) (F) (G)

|7| In a further preferred embodiment of the 1st embodiment of the layer structure according to the invention polythiophene **i)** is a copolymer of monomer units of structure (I) and at least one thiophene monomer selected from the group consisting of 3,4-ethylenedioxythiophene, 2-ethyl-2,3-dihydrothieno[3,4-b]-1,4-dioxine, 2-propyl-2,3-dihydrothieno-[3,4-b]-1,4-dioxine 2-butyl-2,3-dihydrothieno[3,4-b]-1,4-dioxine and 2-decyl-2,3-dihydrothieno[3,4-b][1,4]dioxine, wherein the copolymer comprises 5 to 95 % monomer units, preferably 10 to 80 % monomer units and more preferably 20 to 60 % monomer units of structure (I), in each case based on the total number of thiophene monomer units. This preferred embodiment is a 7th embodiment of the layer structure according to the present invention, that preferably depends on anyone of the 1st and the 3rd to the 5th embodiment. According to a particularly preferred variant of this preferred embodiment of the layer structure according to the present invention the at least one further thiophene monomer is a thiophene monomer selected from the group consisting of 2-ethyl-2,3-dihydrothieno[3,4-b]-1,4-dioxine, 2-propyl-2,3-dihydrothieno-[3,4-b]-1,4-dioxine 2-butyl-2,3-dihydro-thieno[3,4-b]-1,4-dioxine and 2-decyl-2,3-dihydrothieno[3,4-b][1,4]dioxine, wherein the use of 2-butyl-2,3-dihydrothieno[3,4-b]-1,4-dioxine is particularly preferred.

|8| In a preferred embodiment of the 2nd embodiment of the layer structure according to the invention polythiophene **i)** is a characterized by a contact angle higher than 40, preferably higher than 50 and more preferably higher than 60. This preferred embodiment is a 8th embodiment of the layer structure according to the present invention, that preferably depends on the 2nd embodiment.

|9| In a further preferred embodiment of the 2nd embodiment of the layer structure composition according to the invention polythiophene **i)** is a polythiophene comprising monomer units of structure (I)

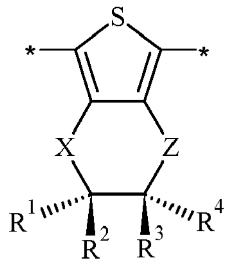

(I)

in which

* indicates the bond to the neighboring monomer units,

X,Z represent O or S,

$R^1$-$R^4$ independently from each other represent a hydrogen atom or an organic residue R, with the proviso that at least one of residues $R^1$ to $R^4$ represents an organic residue R;

This preferred embodiment is a 9th embodiment of the composition according to the present invention, that preferably depends on the 2nd and the 8th embodiment.

|10| In a further preferred embodiment of the 1st and the 2nd embodiment of the layer structure according to the present invention the at least one organic compound **ii)** carrying at least one acid group is an organic compound carrying at least one inorganic acid group, preferably one or two inorganic acid group(s), wherein the inorganic acid group is a sulfonic acid group ($-SO_2OH$), a sulfuric acid group ($-O-SO_2OH$), a phosphonic acid group ($-PO(OH)_2$), a phosphoric acid group ($-O-PO(OH)_2$) or a salt thereof, preferably a sulfonic acid group ($-SO_2OH$) or a salt thereof. This preferred embodiment is a 10th embodiment of the layer structure according to the present invention, that preferably depends on anyone of the 1st to the 9th embodiment.

|11| In a further preferred embodiment of the 1st and the 2nd embodiment of the layer structure according to the present invention the organic compound **ii)** carrying at least one acid group is an anionic surfactant. This preferred embodiment is an 11th embodiment of the layer structure according to the present invention, that preferably depends on anyone of the 1st to the 10th embodiment.

|12| In a further preferred embodiment of the 1st and the 2nd embodiment of th layer structure according to the present invention the at least one organic compound **ii)** carrying at least one acid group is a monovalent sulfonic acid or a salt thereof. Suitable monovalent sulfonic acid are, for example, benzene sulfonic acid, toluene sulfonic acid, ethylbenzene sulfonic acid, dodecylbenzene sulfonic acid, methane sulfonic acid or trifluormethane sulfonic acid or mixtures or salts thereof, wherein the use of dodecylbenzene sulfonic acid is particularly preferred. The term *"dodecyl benzene* sulfonic *acid"* as used herein also encompassed mixtures of alkylbenzene sulfonic acids which, in addition to dodecylbenzene sulfonic acid, further comprises alkylbenzene sulfonic acids with alkyl chains that are longer or shorter than the dodecyl-group. This preferred embodiment is a 12th embodiment of the layer structure according to the present invention, that preferably depends on anyone of the 1st to the 11th embodiment.

|13| In a further preferred embodiment of the 1st and the 2nd embodiment of the layer structure according to the present invention the weight ratio of polythiophene **i)** to at least one organic compound **ii)** carrying at least one acid group in the layer structure is in the range from 1 : 30 to 1 : 0.1, preferably in the range from 1 : 20 to 1 : 0.2 and more preferably in the range from 1 : 5 to 1 : 0.5. This preferred embodiment is a 13th embodiment of the layer structure according to the present invention, that preferably depends on anyone of the 1st to the 12th embodiment.

|14| In a further preferred embodiment of the 1st and the 2nd embodiment layer structure according to the present invention the layer structure comprises the polythiophene **i)** and the organic compound **ii)** carrying at least one acid group in a total amount in the range from 0.01 to 10 wt.-%, more preferably in an amount in the range from 0.2 to 6 wt.-% and most preferably in an amount in the range from 0.5 to 4 wt.-%, for each range based on the total weight of the conductive layer. This preferred embodiment is an 14th embodiment of the layer structure according to the present invention, that preferably depends on anyone of the 1st to the 13th embodiment.

|15| In a further preferred embodiment of the 1st and the 2nd embodiment of the layer structure according to the present invention the at least one ethylenically unsaturated compound **iii)** on which the polymer matrix is based (i. e. from which the polymer matrix has been obtained by radial polymerization) is a compound carrying one or more (meth)acrylic acid-groups, a compound carrying one or more allyl-groups, a compound carrying one or more vinyl-groups

or a compound carrying a combination of at least two of these ethylenically unsaturated groups. This preferred embodiment is an 15th embodiment of the layer structure according to the present invention, that preferably depends on anyone of the 1st to the 14th embodiment.

|16| In a further preferred embodiment of the 1st and the 2nd embodiment of the layer structure according to the present invention the layer structure comprises the polymer forming the polymer matrix in an amount in the range from 30 to 99.99 wt.-%, more preferably in an amount in the range from 50 to 98 wt.-% and most preferably in an amount in the range from 80 to 95 wt.-%, in each case based on the total weight of the conductive layer. This preferred embodiment is a 16th embodiment of the layer structure according to the present invention, that preferably depends on anyone of the 1st to the 15th embodiment.

|17| In a further preferred embodiment of the 1st and the 2nd embodiment of the layer structure according to the present invention the weight ratio of the total weight of polythiophene **i)** and organic compound **ii)** carrying at least one acid group to the weight of the polymer forming the polymer matrix is in the range from 0.1 : 99.99 to 1 : 10, preferably in the range from 0.2 : 99.8 to 5 : 95 and more preferably in the range from 0.5 : 99.5 to 4 : 96. This preferred embodiment is a 17th embodiment of the layer structure according to the present invention, that preferably depends on anyone of the 1st to the 16th embodiment.

|18| In a further preferred embodiment of the 1st and the 2nd embodiment of the layer structure according to the present invention the layer structure preferably has a transmission (including the substrate) of at least 80 %, preferably at least 85 %, more preferably at least 87 % and most preferably at least 89 %. This preferred embodiment is a 18th embodiment of the layer structure according to the present invention, that preferably depends on anyone of the 1st to the 17th embodiment.

A contribution to solving at least one of the objects according to the invention is also made by an electronic component, in particular an organic light-emitting diode, an organic solar cell or capacitors, comprising a layer structure according to the present invention.

A contribution to solving at least one of the objects according to the invention is also made by the use of a composition according to the present invention to produce an electrically conductive layer in an electronic component, in particular in organic light-emitting diodes, organic solar cells or capacitors or to produce an antistatic coating.

Organic compound **ii)** carrying at least one acid group or salt thereof

The organic compound carrying at least one acid group **ii)** or the salt thereof that is present in the composition or the layer structure according to the invention preferably is an anionic surfactant, wherein it is furthermore preferred that the anionic surfactant is selected from the group consisting of organic phosphonic acids, organic phosphoric acids, organic sulfonic acids such as sulfonic acids, such as alkyl-aryl-sulfonic acids, alkyl sulfates, alkyl sulfonates, alkyl ether sulfates, and salts or mixtures thereof. Each of the following anionic surfactants may contain a mixture of compounds varying in the length of the alkyl chain:

- Suitable alkyl sulfates include, but are not limited to, $C_8$-$C_{18}$ alkyl sulfates such as sodium dodecyl sulfate, lithium dodecyl sulfate, ammonium dodecyl sulfate, sodium tetradecyl sulfate, sodium 7-ethyl-2-methyl-4-undecyl sulfate and sodium 2-ethylhexyl sulfate.

- Suitable alkyl ether sulfates include, but are not limited to, $C_8$-$C_{18}$ alkyl ether sulfates such as sodium laureth sulfate and sodium myreth sulfate.

- Suitable alkyl sulfonates include, but are not limited to, $C_8$-$C_{18}$ alkyl sulfonates such as sodium tetradecyl sulfonate, sodium octadecyl sulfonate, sodium dodecyl sulfonate, sodium hexadecyl sulfonate and the corresponding sulfonic acids.

- Suitable aryl sulfonates or sulfonic acids, optionally substituted with alkyl or aryl substituents include, but are not limited to, $C_2$-$C_{18}$ alkylbenzene sulfonates or sulfonic acids such as sodium dodecylbenzene sulfonate, dodecylbenzene sulfonic acid, ethylbenzene sulfonic acid and dodecylbenzene sulfonic acid isopropylamine salt; $C_2$-$C_{18}$ alkyl naphthalene sulfonates or sulfonic acids such as sodium butyl naphthalene sulfonate and sodium hexyl naphthalene sulfonate, especially sodium dodecylbenzene sulfonate or dodecylbenzene sulfonic acid. If optionally substituted with an alkyl substituent, the aryl sulfonate or sulfonic acid may be positioned at any point along the alkyl chain, for example on a primary, secondary or tertiary carbon. Suitable alkyl ester sulfonates or sulfonic acids include, but are not limited to, $C_2$-$C_{18}$ alkyl methyl ester sulfonates or sulfonic acids such as methyl ester sulfonate, sodium dodecyl methyl ester $\alpha$-sulfonate, sodium tetradecyl methyl ester $\alpha$-sulfonate and sodium hexadecyl methyl ester $\alpha$-sulfonate. The sulfate, sulfonate or sulfonic acid groups may be positioned at any point along the alkyl chain or aryl ring, for example on a primary, secondary or tertiary carbon.

- Also suitable are surfactants carrying two sulfonic acid groups such as $C_2$-$C_{16}$ alkyl diphenyl oxide disulfonates or disulfonic acids such as sodium dodecyl diphenyloxide disulfonate.

- Suitable organic phosphonic acids include monovalent phosphonic acids such as phenyl phosphonic acid, 11-hydroxyundecyl phosphonic acid, 2,4-xylyl phosphonic acid, 4-ethylphenyl phosphonic acid, octyl phosphonic acid, octadecyl phosphonic acid, undecyl phosphonic acid, dodecyl phosphonic acid, p-(diphenylmethyl) phosphonic acid, 11-phosphono undecanoic acid and p-(1-naphthalenylmethyl) phosphonic acid, or diphosphonic acids such as (12-phosphonododecyl) phosphonic acid and 1,8-octane diphosphonic acid.

It is, however, particularly preferred that the anionic surfactant is a monovalent sulfonic acid, particularly preferred dodecylbenzene sulfonic acid or a salt thereof.

Ethylenically unsaturated compound **iii)**

The at least one ethylenically unsaturated compound **iii)** is a compound carrying one or more (meth)acrylic acid-groups, a compound carrying one or more allyl-groups, a compound carrying one or more vinyl-groups or a compound carrying a combination of at least two of these ethylenically unsaturated groups.

Preferred compounds carrying (meth)acrylic acid-groups are multifunctional (meth)acrylic acid-monomers selected from the group consisting of neopentyl glycol acrylate, 1,6-hexanediol(meth)acrylate, propylene glycol di(meth)acrylate, triethylene glycol di(meth)acrylate, dipropylene glycol di(meth)acrylate, polyethylene glycol di(meth)acrylate, polypropylene glycol di(meth)acrylate, trimethylolpropane tri(meth)acrylate, trimethylolethane tri(meth)acrylate, 1,2,4-cyclohexane tetra(meth)acrylate, pentaglycerol tri(meth)acrylate, pentaerythritol tetra(meth)acrylate, pentaerythritol tri(meth)acrylate, dipentaerythritol tri(meth)-acrylate, dipentaerythritol penta(meth)acrylate, dipentaerythritol tetra(meth)-acrylate, dipentaerythritol hexa(meth)acrylate, tripentaerythritol tri(meth)acrylate, tripentaerythritol hexatri(meth)acrylate, bis(2-hydroxyethyl)isocyanurate di-(meth)acrylate, hydroxyethyl(meth)acrylate, hydroxypropyl(meth)acrylate, hydroxybutyl(meth)acrylate, isooctyl(meth)acrylate, isodecyl(meth)acrylate, stearyl(meth)acrylate, tetrahydrofurfuryl(meth)acrylate, phenoxyethyl(meth)acrylate, and isobomeol(meth)acrylate.

Also suitable as compounds carrying (meth)acrylic acid-groups are photocurable (meth)acrylate oligomers such as epoxy(meth)acrylates, urethane(meth)acrylates and ester(meth)acrylates.

The urethane(meth)acrylate may be prepared from a multifunctional (meth)acrylate having a hydroxyl group in the molecule and a compound having an isocyanate group in the presence of a catalyst. Specific examples of the (meth)acrylate having a hydroxyl group in the molecule include at least one selected from the group consisting of 2-hydroxyethyl(meth)acrylate, 2-hydroxyisopropyl(meth)acrylate, 4-hydroxybutyl(meth)acrylate, caprolactone ring-opened hydroxyacrylate, pentaerythritol tri/tetra(meth)acrylate mixtures, and dipentaerythritol penta/hexa(meth)actylate mixtures. Specific examples of the compound having an isocyanate group may include at least one selected from the group consisting of 1,4-diisocyanatobutane, 1,6-diisocyanatohexane, 1,8-diiso-cyanatooctane, 1,12-diisocyanatododecane, 1,5-diisocyanato-2-methyl-pentane, trimethyl-1,6-diisocyanatohexane, 1,3-bis(isocyanatomethyl)cyclo-hexane, trans-1,4-cyclohexene diisocyanate, 4,4'-methylenebis(cyclohexyl isocyanate), isophorone diisocyanate, toluene-2,4-diisocyanate, toluene-2,6-diisocyanate, xylene-1,4-diisocyanate, tetramethylxylene-1,3-diisocyanate, 1-chloromethyl-2,4-diiso-cyanate, 4,4'-methylenebis(2,6-dimethylphenyl isocyanate), 4,4'-oxybis(phenyl isocyanate), trifunctional isocyanate derived from hexamethylene diisocyanate, and trimethylene propanol adduct toluene diisocyanate.

Suitable compounds carrying vinyl- or allyl-groups are styrene as well as oligomers end-capped with vinyl ether groups, allyl ether groups or any combinations thereof.

Additives **vi)**

Suitable additives **vi)** which can also be present in the composition according to the present invention include a UV stabilizer, a heat stabilizer, an antioxidant, a UV absorber, a conductivity-improving agent, an adhesion promoter, a polymeric binder, a surfactant, or a combination of at least two of these additives:

- Suitable UV stabilizer may include an absorber, a quencher, and a hindered amine light stabilizer (HALS), as classified depending on the mechanism of action thereof, or may include phenyl salicylate (absorber), benzophenone (absorber), benzotriazole (absorber), a nickel derivative (quencher), and a radical scavenger, as classified depending on the chemical structure thereof. The heat stabilizer may include a polyphenol-based primary heat stabilizer, a phosphite-based secondary heat stabilizer, and a lactone-based secondary heat stabilizer, as commercially applicable products, which may be used alone or in combinations.

- Suitable antioxidants can be selected from the group consisting of hindered amine light stabilizers, such as

bis(2,2,6,6-tetramethylpiperidin-4-yl)-sebacate, bis(1,2,2,6,6-pentamethylpiperidin-4-yl)sebacate and di(1,2,2,6,6-pentamethylpiperidin-4-yl), tetrakis alkylene (dialkylhydroxyaryl) alkyl ester alkanes, such as tetrakis methylene (3,3',5-dibutyl-4'-hydroxyphenyl) proprionate methane, the reaction product of glycidyl methacrylate and p-amino diphenylamine or n-hexyl-N'-phenyl-p-phenylene diamine, pentaerythritol tetrakis(thioglycoate), trimethylol propane tris(thioglycoate), trimethylol ethane tris(thioglycoate), N-(4-anilinophenyl) acrylamide, N-(4-anilinophenyl) meleamic acid, N-(4-anilinophenyl) maleimide, alkylhydroxyphenyl groups with carboalkoxy linkages to heterocyclic nitrogen compounds containing an imidodicarbonyl or imidodithiocarbonyl group, 3,5-di-tertbutyl-4-hydroxy cinnamonitrile, ethyl-di-terthexyl-4-hydroxy-xinnamide, substituted benzyl ethers of beta-substituted hydroxyphenyl propionic acids, bis-(hydroxyphenyl alkylene) alkylisocyanurates, tetrakis hydroxybenzyl phosphonium halides alone or in combination with a dialkylthiodialkanoate, thiodimethylidyne tetrakisphenols alone or in combination with a dialkylthiodialkanoate, phosphite or phosphonates, dihydroxycarbylhydroxy phenyl aryl or alkyl phosphonites, phosphonates, phosphates, phosphites, phosphinates, phosphinites, phosphororthionates, or phosphinothionates, diphenyl bis(3,5-ditertbutyl-4-hydroxyphenoxy) silane, hydrocarbyl hydroxyphenyl dihydrocarbyl dithiocarbamates, such as 3,5-ditertbutyl-4-hydroxy phenyl dimethyldithio carbamate and amino benzyl thioether. Other suitable antioxidants and light stabilizers will be apparent to those skilled in the

- Suitable UV-absorbers may comprises compounds such as dodecyl oxibenzophenone, 2,4-dihydroxybenzophenone, hydroxybenzophenones containing sulfonic acids, 2,4-dihydroxy-3',5'-ditertiary butyl benzophenone, 2,2',4'-trihydroxy benzophenone esters of dicarboxylic acids, 2-hydroxy-4-acryloxyethoxybenzophenone, aliphatic monoesters of 2,2',4'-trihydroxy-4'-alkoxybenzophenone, 2-hydroxy-4-methoxy-2'-carboxybenzophenone, lower alkyl thiomethylene containing phenols, substituted benzenes such as 1,3-bis-(2'hydroxybenzoyl) benzene, metal derivatives of 3,5-di-t-butyl-4-hydroxyphenyl proprionic acid, asymmetrical oxalic acid diarylamides, alkylhydroxyphenylthioalkanoic acid esters, dialkylhydroxyphenyl alkanoic acid esters of di-and tri-pentaerythritol, oxalic acid diamides such as 4,4'-dioctyloxy,5,5'-di-tert-butyl-oxanilide, 2,2'-di-dodecyloxy-5,5'-di-tert-butyl-oxanilide, 2-ethoxy-2'-ethyl-oxanilide, N,N'-bis(3-dimethylaminopropyl)-oxalamide, and 2-ethoxy-5-tert-butyl-2'-ethyloxanilide, phenyl and naphthalene substituted oxalic acid diamides, methyl beta-(3,5-di-tert-butyl-4-hydroxyphenyl)proprionate, $\alpha,\alpha'$-bis-(2-hydroxyphenol)-di-iso-propyl-benzene, 3,5'-dibromo-2'-hydroxy acetophenone, ester derivatives of 4,4-bis-(4'-hydroxyphenyl)pentanoic acid with at least one unsubstituted position ortho to the aromatic hydroxyl groups, organophosphorus sulfides such as bis(diphenylphosphinothioyl)monosulfide and bis(diphenylphosphinothioyl)disulfide, 4-benzoyl-6-(dialkyl-hydroxy-benzyl)resorcinol, bis(3-hydroxy-4-benzoylphenoxy)diphenyl silane, bis(3-hydroxy-4-benzoyl-phenoxy)dialkyl silane, 1,8-naphthalimides, $\alpha$-cyano, $\beta,\beta$,-diphenylacrylic acid derivatives, bis-(2-benzoxazolyl) alkanes, bis-(2-naphththoxa-zolyl)alkanes, methylene malonitriles containing aryl and heterocyclic substitutes, alkylene-bis-dithiocarbanate, 4-benzoyl-3-hydroxyphenoxy ethyl methacrylate, aryl or alkyl substituted acrylonitriles and 3-methyl-5-isopropylphenyl-6-hydroxy coumarone.

- Additives which enhance the conductivity comprise compounds such as for example tetrahydrofuran, lactone group-comprising compounds such as butyrolactone, valerolactone, amide group- or lactam group-comprising compounds such as caprolactam, N-methyl caprolactam, N,N-dimethyl acetamide, N-methyl acetamide, N,N-dimethyl formamide (DMF), N-methyl formamide, N-methyl formanilide, N-methyl pyrrolidone (NMP), N-octyl pyrrolidone, pyrrolidone, sulphones and sulphoxides, such as for example sulpholane (tetramethylene sulphone), dimethyl sulphoxide (DMSO), sugar or sugar derivatives, such as for example sucrose, glucose, fructose, lactose, sugar based surfactants such as Tween or Span 60, sugar alcohols such as for example sorbitol, mannitol, furan derivatives such as for example 2-furan carboxylic acid, 3-furan carboxylic acid, and/or di- or polyalcohols such as for example ethylene glycol, glycerol or di- or triethylene glycol. Tetrahydrofuran, N-methyl formamide, N-methyl pyrrolidone, ethylene glycol, dimethyl sulphoxide or sorbitol are particularly preferably used as conductivity-raising additives.

- Suitable adhesion promoters are compounds such as e.g. organofunctional silanes or hydrolysates thereof, e.g. 3-glycidoxypropyltrialkoxysilane, 3-aminopropyltriethoxysilane, 3-mercaptopropyltrimethoxysilane, 3-methacryloxypropyltrimethoxysilane, vinyltrimethoxysilane or octyltriethoxysilane.

- Suitable polymeric binders are particularly those being soluble in organic solvents, such as polyolefins, polyvinyl acetate, polycarbonate, polyvinyl butyral, polyacrylic acid esters, polyacrylic acid amides, polymethacrylic acid esters, polymethacrylic acid amides, polystyrene, polyacrylonitrile, polyvinyl chloride, polyvinyl pyrrolidones, polybutadiene, polyisoprene, polyethers, polyesters, polyurethanes, polyamides, polyimides, polysulphones, polysilicones, epoxy resins, styrene-acrylate, vinyl acetate/acrylate and ethylene/vinyl acetate copolymers, polyvinyl alcohols or cellulose derivatives, can also be added to the composition. Also suitable as polymeric binders are copolymers of the above-mentioned polymers.

- Suitable surfactants are all amphiphilic compounds which have a hydrophilic head group and a hydrophobic part. The hydrophilic group can be both ionic and non-ionic in nature. Due to the molecular structure and the tendency to attach to interfaces, this class of substances lowers the interfacial tension and leads to improved wetting properties. Suitable surfactants are in particular anionic surfactants, such as paraffin sulfonates, alcohol sulfonates, ether sulfonates, sulfosuccinates, phosphate esters, alkyl ether carboxylic acids or carboxylates, cationic surfactants such as quaternary alkylammonium salts, non-ionic surfactants, such as linear alcohol ethoxylates, oxoalkoholethoxylate, alkylphenolethoxylate or alkylpolyglucoside.

Process for producing the composition according to the present invention

In a first step for the formation of a composition according to the present invention the thiophene monomers are oxidatively polymerised in the presence of the organic compound **ii)** and the organic solvent **iv).** Oxidising agents that are suitable for the oxidative polymerisation of pyrrole can be used as oxidising agents. Preferred oxidising agents are organic peroxides such as tert-butyl peroxide, diisobutyryl peroxide, di-n-propyl peroxydicarbonate, didecanoyl peroxide, dibenzoyl peroxide, tert-butyl peroxybenzoate, di-tert-amyl peroxide can also be used as oxidising agents. Organic azo compounds such as for example 2,2'-azodiisobutyronitrile can also be used. Particularly preferred oxidizing agents are organic, metal-free oxidizing agents such as organic peroxides, wherein dibenzoyl peroxide is most preferred.

The thiophene monomers are oxidatively polymerized - in the presence of the organic compound **ii)** - by reduction of the oxidising agent to a reduction product and oxidation of the thiophene monomer, to form a the polythiophene **i)** and the reduction product, wherein said polymerization preferably takes place at a temperature in the range from 0°C to 100°C. In this context it is particularly preferred that the reaction temperature is in a range from 25°C up to a temperature that is below the lowest boiling point of the solvents comprised in the reaction mixture.

The anions **ii)** that are present in the reaction mixture serve as counterions to compensate that positive charge of the polythiophenes **i).** Anions **ii)** and polythiophenes **i)** are preferably present in the form of a polythiophene/anion-complex. In this context it is also preferred that in a composition is obtained that comprises the polythiophene **i)** and the anions **ii)** in the form of such a complex, wherein it is particularly preferred that the composition is present in the form of a dispersion comprising the organic solvent **iv)** in which this complex is dispersed.

In a subsequent process step further components, particularly the at least one ethylenically unsaturated compound **iii)** that is polymerizable in a radical chain reaction and other additives such as radical initiators etc. can be added to the dispersion thus obtained.

The invention is now described in more detail by reference to figures, test methods and non-limiting examples.

TEST METHODS

Solids content

The solid content was determined by gravimetry using a precision scale (Mettler AE 240). First the empty weighing bottle including lid is weight in (Weight A). Then ca. 3 g of dispersion to be analyzed is filled quickly into the bottle, closed by the lid and weighed again to determine the exact total weight B. The bottle is then placed in a fume hood without a lit for ca. 3 hours to allow the evaporation of volatile solvents at room temperature. In a second step the bottle is placed in a drying oven with ventilation (Memmert UNB200) at 160 °C for 16 - 17 hours. When the sample bottle is removed from the oven, immediate coverage by the glass lid is important due to the hygroscopic nature of the dry dispersion material. After 10 - 15 min of cooling down period the bottle is weighed again including lid to determine weight C.

Calculation of the solid contents: wt.% solids content = 100 $\times$ (C-A)/(B-A)

The result is the average of two measurement.

Determination of solids / solids [%]

Solids / solids [%] is determined by calculating the applied solids of the conductive dispersion (in gram as base unit) by using the given solids content and the applied amount of the dispersion. The value is then divided by the total amount of solids present in the coating mixture, again using gram as the base unit.

Preparation of films on PET substrates

The dispersion was applied to a PET substrate (Melinex 506 , thickness 175 $\mu$m) at room temperature using a manual wire-bar (close wound K bar from RK Print-Coat Instruments Ltd.) which had a gap separation of either 6 $\mu$m or 12 $\mu$m. The gap separation of the manual doctor blade in this context determines the thickness of the wet film formed, which is also called the wet film thickness. The coatings or films formed in this way were then dried in a drying oven at

for the given times and temperatures. Before any further processing, the coated PET substrate was cooled to room temperature.

If no other parameters are stated in the experiments, the wet film thickness was chosen to be 12 μm and the drying process took place at 130 °C for 15 minutes,

Determination of the surface resistivity

The surface resistivity was measured with a Staticide ACL 800 Digital Megohm-meter at the 100 V setting. Two measurements on different positions on the sheet were conducted and the lowest value was taken as the result.

Solvent-compatibility as determined by the RF value

1 g of the conductive dispersion is placed in a 30 mL screw-lid bottle. Under gentle shaking, 9 g of the solvent (for example PGME) are added slowly under continued shaking over the course of 2 minutes. After the addition of the solvent is completed, the gentle shaking is continued for 3 additional minutes to ensure an evenly distribution of the dispersion in the solvent. After that, a sample of the mixture is immediately pulled into a 2 mL plastic pipette (VWR, REF 612-2849). One droplet of the mixture in the plastic pipette is now applied to a 5 × 5 cm piece of filter paper (Schleicher & Schuell, 595 Rundfilter, REF.-No.: 311621). The resulting circle is closely observed, to determine the end of the spreading of the droplet in the filter paper. Once the spreading has come to a dead stop, the boarders of the forming circles are marked with a pencil to prevent changes due to evaporation of the solvent. The formed pattern will result in two circles: one inner circle from the solids in the mixture and one outer circle from the solvent. The diameter of both circles is determined using a ruler, thereby making sure to determine the diameter through the common center point of both circles. Figure 1 visualizes the determination of the dimeters, with A being the diameter of the outer circle and B being the diameter of the inner circle.

The $RF_1$-value is now determined after the following equation:

$$RF_1 = B/A$$

A second RF-value, $RF_2$, is determined in the same fashion with the same pattern, but orthogonally to the first measurement, making again sure that the determination of the diameter takes place through the common center point of both circles.

The RF-value is now calculated by averaging $RF_1$ and $RF_2$:

$$RF = \frac{RF_1 + RF_2}{2}$$

Determination of the transmission

The total transmittance was measured with a Haze-Guard Plus, Illum. C (Byk-Gardner GmbH). The coated PET substrate is pressed by a spring-holder against the entrance port of the photometer sphere with the coating facing towards the sphere. The measurement area is 18mm in diameter. The readout displays the transmission of the coated PET-substrate. The transmission of the uncoated PET substrate (Melinex 506 , thickness 175 μm) is 90,5%.

FIGURES

Figure 1 shows the determination of the dimeters of the two circles when determining the solvent compatibility (for details see the text method for the determination of the solvent-compatibility).

Figure 2 shows the structure of a layer structure 100 according to the invention, for example an antistatic film, in general form. On the substrate surface of a substrate 101, in the case of an antistatic film often a PE, PP or PET layer, is an electrically conductive layer 102 that has been prepared with the composition according to the invention.

EXAMPLES

Example 1

(Reference Example for the synthesis of 3-(2-ethylhexoxymethyl)-2,3-dihydrothieno[3,4-b][1,4]dioxine)

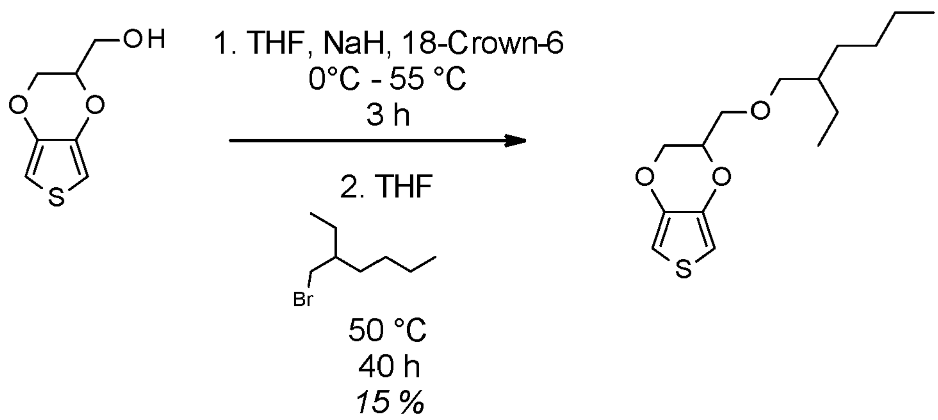


The synthesis is conducted under dry and inert conditions.

THF (60 mL) and 18-Crown-6 (0.200 g, 0.8 mmol) are added to the reaction vessel. NaH (1.512 g, 37.8 mmol) as 60 % suspension in oil is added under stirring, the mixture is stirred at room temperature. At 0 °C a EDOT-MeOH (5.00 g, 29.0 mmol) solution in 20 mL THF is added to the NaH solution. After addition of the solution the reaction mixture is stirred for 2.5 h at room temperature, subsequently 0.5 h at 55 °C. Reaction mixture is cooled to 0 °C and a 2-ethylhexyl bromide (7.300 g, 37.8 mmol) solution in 20 mL THF is added. The reaction mixture is stirred for 1 h at room temperature and 40 h at 50 °C. The reaction mixture is cooled to room temperature and quenched with a mixture of isopropanol/water 70 : 30 (v/v). The crude product was purified by column chromatography.

The reaction product (3-(2-ethylhexoxymethyl)-2,3-dihydrothieno[3,4-b][1,4]-dioxine) is obtained as a yellow oil in a yield of 15 %.

Example 2

A 250 mL three-necked round-bottom flask equipped with mechanical stirrer was charged with 65 g anisole (Aldrich), 2.699 g of dibenzoyl peroxide (11.1 mmol; Aldrich), and 2.981 g 4-dodecylbenzenesulfonic acid (9.3 mmol, Aldrich). After heating to 60 °C 1.185 g of 3-butyl-2,3-dihydrothieno[3,4-b][1,4]dioxine (6 mmol; ButylEDOT; CAS 552857-06-4, Synmax Biochemical, Taiwan) and 1.134 g product obtained from the reaction in Example 1 (4 mmol) dissolved in 20 g of anisole were added over 40 min. The dispersion was stirred for another 3 h at 60 °C and then cooled to room temperature.

50 g of the dispersion, 30 g anisole, and 20 g of n-butanol are added to a 100 mL flask and mixed via gentle stirring of the resulting dispersion.

This is called dispersion 2.

Analysis of dispersion 2:

| | |
|---|---|
| Solids content: | 2.3% (gravimetric) |
| Sheet resistance (12 μm on PET): | 170000 Ohm/sq |
| RF(PGME): | 1 |
| RF(MTBE): | 0.4 |

The ion-content of dispersion 2 was measured by inductively coupled plasma optical emission spectrometry:

| | | |
|---|---|---|
| Na | 0.324 | ppm |
| Fe | 0.043 | ppm |

(continued)

| | | |
|---|---|---|
| Cu | 0.000 | ppm |
| Pb | 0.000 | ppm |
| B | 0.010 | ppm |
| Mo | 0.370 | ppm |
| Al | 0.000 | ppm |
| Cr | 0.028 | ppm |
| Co | 0.000 | ppm |
| Mn | 0.000 | ppm |
| Ni | 0.000 | ppm |
| V | 0.000 | ppm |
| Zn | 0.514 | ppm |
| Ca | 0.172 | ppm |
| K | 0.000 | ppm |
| Mg | 0.077 | ppm |
| Cd | 0.012 | ppm |

Example 3

A 250 mL three-necked round-bottom flask equipped with mechanical stirrer was charged with 65 g anisole (Aldrich), 2.699 g of dibenzoyl peroxide (11.1 mmol; Aldrich), and 2.981 g 4-dodecylbenzenesulfonic acid (9.3 mmol, Aldrich). After heating to 60 °C 1.422 g EDOT (10 mmol, CAS 126213-50-1, Heraeus) dissolved in 20 g of anisole were added over 40 min. The dispersion was stirred for another 3 h at 60 °C and then cooled to room temperature.
50 g of the dispersion, 30 g anisole, and 20 g of n-butanol are added to a 100 mL flask and mixed via gentle stirring of the resulting dispersion.
This is called dispersion 3.
Analysis of dispersion 3:

| | |
|---|---|
| Solids content: | 1.8% (gravimetric) |
| Sheet resistance (12 μm on PET): | 5800 Ohm/sq |
| RF(PGME): | 0.4 |

Example 4

A 250 mL three-necked round-bottom flask equipped with mechanical stirrer was charged with 65 g anisole (Aldrich), 2.699 g of dibenzoyl peroxide (11.1 mmol; Aldrich), and 1.732 g ethyl benzenesulfonic acid (9.3 mmol, Aldrich). After heating to 60 °C 1.185 g of 3-butyl-2,3-dihydrothieno[3,4-b][1,4]dioxine (6 mmol; ButylEDOT; CAS 552857-06-4, Synmax Biochemical, Taiwan) and 1.134 g product obtained from the reaction in Example 1 (4 mmol) dissolved in 20 g of anisole were added over 40 min. The dispersion was stirred for another 3 h at 60 °C and then cooled to room temperature.
50 g of the dispersion, 30 g anisole, and 20 g of n-butanol are added to a 100 mL flask and mixed via gentle stirring of the resulting dispersion.
This is called dispersion 4.
Analysis of dispersion 4:

| | |
|---|---|
| Solids content: | 1.2% (gravimetric) |
| Sheet resistance (12 μm on PET): | 170000 Ohm/sq |
| RF(PGME): | 1 |

Example 5

(According to the teaching of WO-A-2012/059215)

A 1 L three-necked round-bottom flask equipped with mechanical stirrer was charged with 294 g anisole (Aldrich),

9.4 g of dibenzoyl peroxide (39 mmol; Aldrich), 8.25 g of a sulfonated block-copolymer (Kraton Nexar® MD) and 7.2 g of para-toluene sulfonic acid (38 mmol, Aldrich). After heating to 60 °C 4.95 g of 3,4-ethylenedioxythiophene (35 mmol; Clevios M V2; Heraeus Deutschland GmbH & Co KG, Germany) dissolved in 20 g of anisole were added over 40 min. The dispersion was stirred for another 3 h at 60 °C and then cooled to room temperature.

20 g of the dispersion obtained after filtration and 20 g of butyl acetate were mixed in a 50 ml glass bottle and subjected to 2 min or ultrasound treatment (Hielscher UP 200 S, cycle 1, amplitude 100%). This sample is called dispersion 5.

Analysis of dispersion 5:

| | |
|---|---|
| Solids content: | 2.5 % (gravimetric) |
| Sheet resistance (12 μm on PET): | 17,000 Ohm/sq |
| RF(PGME): | 0.4 |

Example 6

Dispersion 2, dispersion 3, dispersion 4, dispersion 5 and Clevios PH 1000 (aqueous PEDOT:PSS Dispersion, Heraeus) were tested with respect to their compatibility with SR 399 from Sartomer (CAS 384855-91-7) and with 1-hydroxycyclohexyl phenyl ketone from Sigma Aldrich as photoinitiator in PGME as solvent. Table 1 shows the amounts of the used compounds.

The components were thoroughly mixed by stirring, starting with the conductive dispersions, followed by PGME, the SR399 and finally the photo initiator. The mixtures were stirred for 15 minutes in the dark.

Using a wire-bar a 6 μm wet film was deposited on a PET substrate and dried for 3 min at 75°C in an oven. After drying, the coated sheets were exposed with 600 mJ/cm$^2$ in an UV-chamber. The surface resistivity and the transmission including the PET-sheet were determined.

Table 1

| Example | solids/ solids [%] | dispersion | PGME [g] | SR 399 [g] | photoinitiator [g] | surface resistivity [Ohm/sq] | trans-mission [%] |
|---|---|---|---|---|---|---|---|
| 6A | 2 | 0.840g disp. 5 | 1.541 | 1 | 0.05 | $3.8 \times 10^{11}$ | 91.6 |
| 6B | 3 | 1.260g disp. 5 | 1.121 | 1 | 0.05 | $4.7 \times 10^{11}$ | 91.4 |
| 6C | 5 | 2.100g disp. 5 | 0.281 | 1 | 0.05 | $4.6 \times 10^{11}$ | 90.8 |
| 6D | 0.17 | 0.173g PH 1000 (aqueous) | 2.208 | 1 | 0.05 | $3.5 \times 10^{11}$ | 91.8 |
| 6E | 0.5 | 0.510g PH 1000 (aqueous) | 1.871 | 1 | 0.05 | precipitation | precipitation |
| 6F | 1 | 1,091g PH 1000 (aqueous) | 1.362 | 1 | 0.05 | precipitation | precipitation |
| 6G | 2 | 2.039g PH 1000 (aqueous) | 0.342 | 1 | 0.05 | precipitation | precipitation |
| 6H | 2 | 1.167g disp. 3 | 1.214 | 1 | 0.05 | $5.5 \times 10^{11}$ | 90.7 |
| 6I | 3 | 1.750g disp. 3 | 0.631 | 1 | 0.05 | $5.0 \times 10^{11}$ | 90.0 |
| 6J | 4 | 2.333g disp. 3 | 0.048 | 1 | 0.05 | $2.4 \times 10^{11}$ | 88.0 |
| 6K* | 2.0 | 0.909g disp. 2 | 1.471 | 1 | 0.05 | $7.9 \times 10^{9}$ | 89.5 |
| 6L* | 3.0 | 1.370g disp. 2 | 1.011 | 1 | 0.05 | $3.7 \times 10^{8}$ | 88.5 |
| 6M* | 4.0 | 1.826g disp. 2 | 0.555 | 1 | 0.05 | $2.5 \times 10^{8}$ | 87.4 |
| 6N* | 5.0 | 2.283g disp. 2 | 0.098 | 1 | 0.05 | $2.0 \times 10^{8}$ | 86.1 |
| 6O* | 0.5 | 0.455g disp. 4 | 1.925 | 1 | 0.05 | $7.5 \times 10^{9}$ | 90.6 |
| * = inventive | | | | | | | |

Examples 6A, 6B and 6C demonstrate that dispersions using polyanions do not achieve an acceptable sheet resistance.

Examples 6D, 6E, 6F and 6G demonstrate that aqueous dispersions do not achieve a sufficient sheet resistance at low portions. At higher portions, significant precipitation is observed (examples 6E, 6F and 6G).

Examples 6H, 6I and 6J demonstrate that dispersions using EDOT and a monovalent sulfonic acid, although processing superior sheet resistant of initial dispersion, do not produce an acceptable sheet resistant in the cured film.

Examples 6K, 6L, 6M, 6N and 6O demonstrate the superior performance of dispersion containing a branched-EDOT.

Example 7

The example demonstrates the negative impact of water in antistatic, solvent based hardcoating formulations.

Coating premix A was prepared by combining dispersion 2 (1,370g), PGME (1.011g), SR399 (1g, Sartomer) and 1-hydroxycyclohexyl phenyl ketone (0.05g, Sigma Aldrich). The components were thoroughly mixed by stirring. Afterwards, premix A was combined with deionized water at the amounts given in table 2. The mixtures were stirred for one hour. Afterwards, the coating was applied to a Melinex 506 PET substrate as 6μm wet film, dried for 3 minutes at 75 °C and exposed to UV-irradiation at 600 mJ/cm². The surface resistivity was determined.

Table 2

| example | water content [%] | water [g] | premix A [g] | surface resistivity [Ohm/sq] |
|---|---|---|---|---|
| 7A | 0.1 | 0.005 | 4.995 | $5.6 \times 10^9$ |
| 7B | 0.5 | 0.025 | 4.975 | $8.6 \times 10^9$ |
| 7C | 1 | 0.05 | 4.950 | $1.8 \times 10^{10}$ |
| 7D | 2 | 0.1 | 4.900 | $5.6 \times 10^{11}$ |
| 7E | 5 | 0.25 | 4.750 | $9.4 \times 10^{11}$ |

As demonstrated in example 7D, a water content of 2% and more causes the loss of the antistatic function of the hard coating.

Example 8

The coatings were prepared by mixing the components shown in table 3. 1-hydroxycyclohexyl phenyl ketone (Sigma Aldrich) was used as the photo initiator. The DPHA was purchased by Sigma Aldrich (dipentaerythrit-penta-/hexaacrylat, CAS 60506-81-2) The components were thoroughly mixed by stirring. The mixtures were stirred for 15 minutes. Afterwards, the coating was applied to a Melinex 506 PET substrate as 12μm wet film, dried for 3 minutes at 75 °C and exposed to UV-irradiation at 600 mJ/cm². The surface resistivity and the transmission were determined.

Table 3

| example | solids/ solids [%] | dispersion [g] | DPHA [g] | initiator [g] | PGME [g] | SR [Ohm/sq] | T [%] |
|---|---|---|---|---|---|---|---|
| 8A | 0% | 0 g | 0.95 | 0.05 | 10 | $1 \times 10^{12}$ | 91.5 |
| 8B | 2.00% | 0.886 g dispersion 2 | 0.95 | 0.05 | 9.114 | $1.3 \times 10^{10}$ | 90.1 |
| 8C | 3.00% | 1.345 g dispersion 2 | 0.95 | 0.05 | 8.655 | $1.8 \times 10^9$ | 89.5 |
| 8D | 5.00% | 2.29 g dispersion 2 | 0.95 | 0.05 | 7.71 | $4.3 \times 10^8$ | 88.2 |
| 8E | 7.00% | 3.275 g dispersion 2 | 0.95 | 0.05 | 6.725 | $1.2 \times 10^8$ | 86.8 |
| 8F | 10.00% | 4.83 g dispersion 2 | 0.95 | 0.05 | 5.17 | $4.1 \times 10^7$ | 85.2 |

Example 9

The example demonstrates the difference in pencil hardness between a cured and a non-cured composition according to the invention. An additional example demonstrates the differences between a cured coating from a composition according to the invention to coating from a composition containing already polymerized acrylates.

The coatings were prepared by mixing the components shown in table 4. 1-Hydroxycyclohexyl phenyl ketone (Sigma Aldrich) was used as the photo initiator. The SR399 was purchased by Sartomer. The components were thoroughly mixed by stirring. The mixtures were stirred for 15 minutes. Afterwards, the coating was applied to a glass substrate as 12 μm wet film, and dried for 3 minutes at 75 °C.

Example 9A was additionally exposed to UV-irradiation at 600 mJ/cm$^2$.

The pencil hardness of the resulting coatings was determined according to the Wolf-Wilburn pencil hardness test. In the test, a pencil with hardness H was equipped to the 5800 Scratch resistance kit from BYK instruments. The instrument was then pushed over the coated glass substrates. The coating was closely inspected afterwards. If no damage to the coating was observed, a pencil with one H hardness point higher was attached to the 5800 Scratch resistance kit, and the measurement was repeated at another position. The pencil hardness given in table 4 is the first pencil hardness that will cause a visible damage of the coating.

Table 4

| example | solids/ solids [%] | dispersion [g] | binder [g] | initiator [g] | PGME [g] | pencil hardness |
|---|---|---|---|---|---|---|
| 9A (inventive) | 2 | 0.913g dispersion 2 | 1 g SR399 | 0.05 | 1.468 | 8H |
| 9B | 2 | 0.913g dispersion 2 | 1 g SR399 | 0 | 1.468 | <1H |
| 9C | 2 | 0.913g dispersion 2 | 1g polybutyl methacrylate | 0 | 1.468 | <1H |

Example 10

The example demonstrates the performance of dispersion 2 and dispersion 4 in cured compositions based on various organic solvents. Additionally, it demonstrates that the RF-value determined in PGME generally predicts the performance of the conductive dispersion in a composition according to the invention independently of the used solvent.

RF value of dispersion 2 in PGME: 1

RF value of dispersion 3 in PGME: 0.4

The coatings were prepared by mixing the components shown in table 5 with, 0.05g 1-hydroxycyclohexyl phenyl ketone (Sigma Aldrich, photo initiator) and 0.95g DPHA (Sigma Aldrich, dipentaerythrit-penta-/hexaacrylat, CAS 60506-81-2). The components were thoroughly mixed by stirring. The mixtures were stirred for 15 minutes. Afterwards, the coating was applied to a Melinex 506 PET substrate as 12μm wet film, dried for 3 minutes at 75 °C and exposed to UV-irradiation at 600 mJ/cm$^2$. The surface resistivity was determined.

Table 5

| Example | Dispersion | Solvent | Surface Resistivity [Ohm/sq] |
|---|---|---|---|
| 10A (inventive) | 1.345g disp. 2 | 8.655g PGME | $2 \times 10^9$ |
| 10B (inventive) | 1.345g disp. 2 | 8.655g isopropanol | $2 \times 10^9$ |
| 10C (inventive) | 1.345g disp. 2 | 8.655g ethyl acetate | $2 \times 10^9$ |
| 10D (inventive) | 1.345g disp. 2 | 8.655g butyl acetate | $2 \times 10^9$ |
| 10E (inventive) | 1.345g disp. 2 | 8.655g butyl benzoate | $8 \times 10^9$ |
| 10F (inventive) | 1.345g disp. 2 | 8.655g MEK (Butan-2-on) | $2 \times 10^9$ |
| 10G | 1.750g disp. 3 | 8.25g PGME | $5 \times 10^{11}$ |
| 10H | 1.750g disp. 3 | 8.25isopropanole | $5 \times 10^{11}$ |
| 10I | 1.750g disp. 3 | 8.25g ethyl acetate | $5 \times 10^{11}$ |
| 10J | 1.750g disp. 3 | 8.25g butyl acetate | $5 \times 10^{11}$ |
| 10K | 1.750g disp. 3 | 8.25g butyl benzoate | $5 \times 10^{11}$ |
| 10L | 1.750g disp. 3 | 8.25g MEK (butane-2-on) | $5 \times 10^{11}$ |

EXAMPLE 11

The contact angles of water on coated films from dispersion 2 and dispersion 3 were determined. One coated PET sheet from each of the dispersions was produced by applying a 12 μm wet film of the dispersion on a Melinex 506 PET sheet and drying the resulting coated sheet for 15 minutes at 130 °C.

The contact angle of a water droplet was now determined using a Krüss FM40 Easy Drop device. For the determination of the contact angle, a syringe filled with deionized water was attached to the device. A 2 μL droplet was now placed on the coated PET sheet. The contact angle was determined two seconds after the application of the droplet using the "tangent-2" fitting method. The measurements were repeated with three water droplets on three positions of the PET film. The reported value was obtained by averaging the conducted measurements. The obtained results are shown in table 6.

Table 6

| Example | Dispersion | Contact angle [°] |
|---|---|---|
| 11A (inventive) | Dispersion 2 | 68 |
| 11B | Dispersion 3 | 20 |

LIST OF REFERENCE NUMERALS

**100** layer body

**101** substrate

**102** electrically conductive layer

**Claims**

**1.** A composition comprising

**i)** at least one polythiophene comprising monomer units of structure (I)

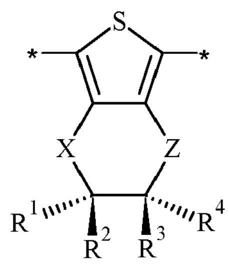

(I)

in which

* indicates the bond to the neighboring monomer units,
X,Z represent O or S,
$R^1$-$R^4$ independently from each other represent a hydrogen atom or an organic residue R, with the proviso that at least one of residues $R^1$ to $R^4$ represents an organic residue R;

**ii)** at least one organic compound carrying at least one acid group, preferably one or two sulfonic acid group(s), one or two sulfuric acid group(s), one or two phosphonic acid group(s) or one or two phosphoric acid group(s), or a salt of said organic compound, wherein the molecular weight of the organic compound or the salt thereof

is less than 1,000 g/mol;
**iii)** at least one ethylenically unsaturated compound, preferably at least one ethylenically unsaturated compound that is polymerizable in a radical chain reaction;
**iv)** at least one organic solvent;
**v)** at least one radical initiator.

**2.** A composition comprising

**i)** at least one polythiophene which is **characterized by** its compatibility in PGME (1-methoxypropan-2-ol), demonstrated by an RF-value of at least 0.8;
**iii)** at least one ethylenically unsaturated compound, preferably at least one ethylenically unsaturated compound that is polymerizable in a radical chain reaction;
**iv)** at least one organic solvent;
**v)** at least one radical initiator.

**3.** The composition according to claim 1, wherein the polythiophene i) is homopolymer or copolymer comprising monomer units of structure (I) in which X and Z represent O, and wherein three of the residues selected from the group consisting of $R^1$, $R^2$, $R^3$ and $R^4$ represent a hydrogen atom and the remaining residue represents an ether group having the structural formula (Ia)

$$-(CR^7R^8)_n\text{-O-}R^9 \qquad \text{(Ia)}$$

wherein

$R^7$ is H, a $C_1$-$C_{10}$-alkyl group or a $C_1$-$C_{10}$-alkoxy group, preferably H;
$R^8$ is H, a $C_1$-$C_{10}$-alkyl group or a $C_1$-$C_{10}$-alkoxy group, preferably H;
n is an integer in the range from 0 to 10; and
$R^9$ is an alkyl group, an alkoxy group, an aryl group, an ether group or an ester group, preferably a $C_1$-$C_{30}$ alkyl group.

**4.** The composition according to claim 1, wherein the polythiophene i) is a homopolymer or copolymer comprising monomer units of structure (I) in which X and Z represent O, and wherein three of the residues selected from the group consisting of $R^1$, $R^2$, $R^3$ and $R^4$ represent a hydrogen atom and the remaining residue represents a branched alkyl group or a branched ether group.

**5.** The composition according to claim 4, wherein the remaining residue represents a branched ether group having the structural formula (Ib)

$$-(CR^{10}R^{11})_n\text{-O-}R^{12} \qquad \text{(Ib)}$$

wherein

$R^{10}$ is H, a $C_1$-$C_{10}$-alkyl group or a $C_1$-$C_{10}$-alkoxy group;
$R^{11}$ is H, a $C_1$-$C_{10}$-alkyl group or a $C_1$-$C_{10}$-alkoxy group;
n is an integer in the range from 0 to 10; and
$R^{12}$ is a branched organic residue, preferably a branched alkyl group or a branched arylalkyl group, more preferably a branched alkyl group or a branched arylalkyl group that do not carry an unsaturated C=C-bond in the alkyl chain.

**6.** The composition according to anyone of claims 1 and 3 to 5, wherein the at least one organic compound **ii)** carrying one acid group is a monovalent sulfonic acid or a salt thereof.

**7.** The composition according to anyone of claims 1 to 6, wherein the at least one ethylenically unsaturated compound **iii)** is a compound carrying one or more (alk)acrylic acid-groups, preferably one or more (meth)acrylic acid-groups, a compound carrying one or more allyl-groups, a compound carrying one or more vinyl-groups or a compound carrying a combination of at least two of these ethylenically unsaturated groups.

**8.** The composition according to anyone of claims 1 to 7, wherein the at least one organic solvent **iv)** is selected from

the group consisting of acetone, methyl ethyl ketone, methyl isobutyl ketone, toluene, xylene, anisole, methyl benzoate, ethyl benzoate, propyl benzoate, butyl benzoate, methyl acetate, ethyl acetate, propyl acetate, butyl acetate, octyl acetate, methyl propionate, ethyl propionate, propyl propionate, butyl propionate, 1-methoxy-2-propylacetat, 1-methoxy-2-propanol, butanol, 2-propanol, ethanol and mixtures thereof or mixtures of one or two of these aprotic solvents with one or two further solvents.

**9.** The composition according to anyone of claims 1 to 8, wherein the at least one radical initiator is a photo-radical initiator capable of forming a radical upon irradiation with light.

**10.** The composition according to anyone of claims 1 to 9, wherein the composition has a water content of less than 2 wt.-%, based on the total weight of the composition.

**11.** A process for the preparation of a layer structure (100), comprising the process steps of

**A)** provision of a substrate (101);
**B)** coating the substrate (101) with a composition according to anyone of claims 1 to 10;
**C)** optionally at least partial removal of the organic solvent **iv);**
**D)** exposing the coated substrate (101) to electromagnetic radiation, to electron beams, to heat or to a combination of at least two thereof, in order to cure the composition by polymerizing the at least one ethylenically unsaturated compound **iii)** in a radical chain reaction.

**12.** A layer structure (100), comprising

**a)** a substrate (101);
**b)** a conductive layer (102) coated onto the substrate (101), wherein the conductive layer (102) comprises

- at least one polythiophene comprising monomer units of structure (I)

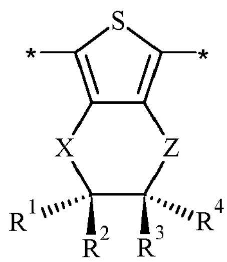

(I)

in which

* indicates the bond to the neighboring monomer units,
X,Z represent O or S,
$R^1$-$R^4$ independently from each other represent a hydrogen atom or an organic residue R, with the proviso that at least one of residues $R^1$ to $R^4$ represents an organic residue R;

- at least one organic compound **ii)** carrying at least one acid group, preferably one or two sulfonic acid group(s), one or two sulfuric acid group(s), one or two phosphonic acid group(s) or one or two phosphoric acid group(s), or a salt of said organic compound, wherein the molecular weight of the organic compound or the salt thereof is less than 1,000 g/mol;
- a polymer matrix based on a polymerized ethylenically unsaturated compound **iii)** into which the at least one polythiophene is embedded;

wherein the conductive polymer layer has a pencil hardness of at least 1H.

**13.** A layer structure (100), comprising

**a)** a substrate (101);
**b)** a conductive layer (102) coated onto the substrate (101), wherein the conductive layer (102) comprises

- at least one polythiophene which is **characterized by** its compatibility in PGME (1-methoxypropan-2-ol), demonstrated by an RF-value of at least 0.8;
- a polymer matrix based on a polymerized ethylenically unsaturated compound **iii)** into which the at least one polythiophene is embedded;

wherein the conductive polymer layer has a pencil hardness of at least 1H.

**14.** An electronic component comprising a layer structure (100) according to claim 12 or 13.

**15.** The use of a composition according to anyone of claims 1 to 10 to produce an electrically conductive layer in an electronic component or to produce an antistatic coating.

Fig. 1

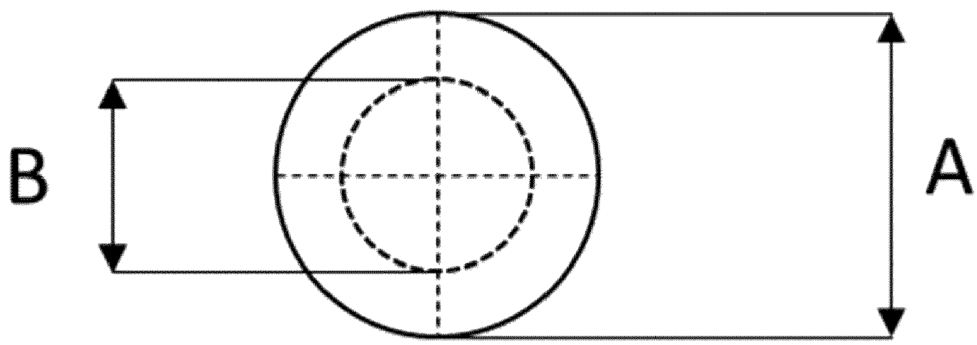

Fig. 2

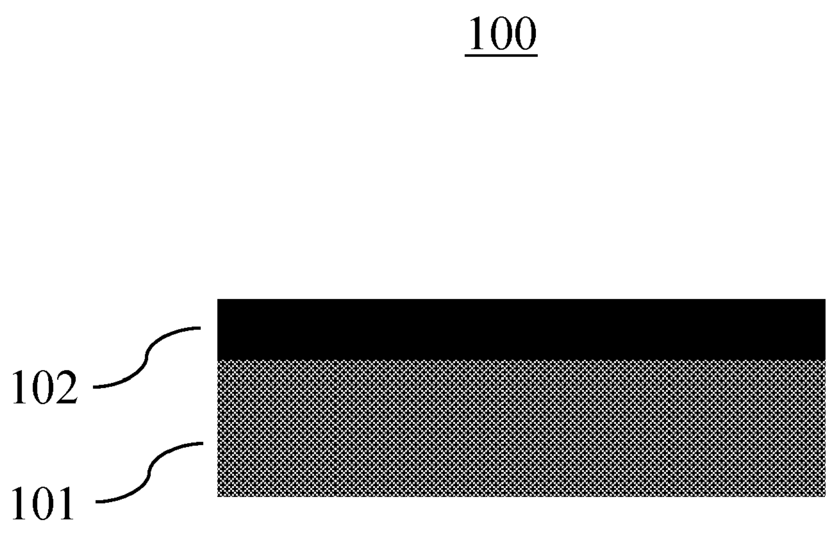

Europäisches Patentamt
European Patent Office
Office européen des brevets

# EUROPEAN SEARCH REPORT

Application Number
EP 21 18 1835

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2021 046361 A (TOSOH CORP; SAGAMI CHEM RES INST) 25 March 2021 (2021-03-25)<br>* paragraph [0001] - paragraph [0093]; claim 1; examples *<br>----- | 1-15 | INV.<br>C08G61/12<br>C08K5/00<br>C08L65/00<br>C09K11/06<br>G01N27/327<br>H01B1/00<br>H01L51/00<br>H05K3/00 |
| X | US 2014/106122 A1 (EGUCHI JUNYA [JP] ET AL) 17 April 2014 (2014-04-17)<br>* paragraph [0001] - paragraph [0247]; claims 1-20; examples *<br>----- | 1-15 | |
| X | WO 2008/022908 A1 (AGFA GEVAERT [BE]) 28 February 2008 (2008-02-28)<br>* page 1, line 5 - page 32, line 32; claims 1-22; examples *<br>----- | 1-15 | |
| X | EP 2 309 519 A1 (NISSAN CHEMICAL IND LTD [JP]) 13 April 2011 (2011-04-13)<br>* paragraph [0001] - paragraph [0045]; claims 1-7; examples *<br>----- | 1-15 | |
| X | JP 2017 222831 A (TOSOH CORP) 21 December 2017 (2017-12-21)<br>* paragraph [0001] - paragraph [0102]; claims 1-6; examples *<br>----- | 1-15 | TECHNICAL FIELDS SEARCHED (IPC)<br>C08G<br>H05B<br>G01N |
| X | DE 10 2020 114473 A1 (KEMET ELECTRONICS CORP [US]) 10 December 2020 (2020-12-10)<br>* paragraph [0002] - paragraph [0074]; claims 1-54; examples *<br>----- | 1-15 | H05K<br>C08K<br>C08L<br>C09K<br>H01B |
| X | WO 2015/095758 A1 (UNIV CALIFORNIA [US]) 25 June 2015 (2015-06-25)<br>* paragraph [0003] - paragraph [0104]; claims 1-38; examples *<br>----- | 1-15 | H01L |

-/--

1 The present search report has been drawn up for all claims

| Place of search | Date of completion of the search | Examiner |
|---|---|---|
| The Hague | 14 December 2021 | Kiebooms, Rafaël |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

page 1 of 2

Europäisches Patentamt
European Patent Office
Office européen des brevets

# EUROPEAN SEARCH REPORT

Application Number
EP 21 18 1835

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/207113 A1 (ZHA BAO [CN]) 4 July 2019 (2019-07-04) * paragraph [0002] - paragraph [0079]; claims 1-20; examples * ----- | 1-15 | |
| X,D | WO 2021/063956 A1 (HERAEUS DEUTSCHLAND GMBH & CO KG [DE]) 8 April 2021 (2021-04-08) * page 1, line 7 - page 49, line 15; claims 1-22; examples * ----- | 1-15 | |

TECHNICAL FIELDS SEARCHED (IPC)

1 The present search report has been drawn up for all claims

| Place of search | Date of completion of the search | Examiner |
|---|---|---|
| The Hague | 14 December 2021 | Kiebooms, Rafaël |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 21 18 1835

This annex lists the patent family members relating to the patent documents cited in the above-mentioned European search report. The members are as contained in the European Patent Office EDP file on
The European Patent Office is in no way liable for these particulars which are merely given for the purpose of information.

14-12-2021

| Patent document cited in search report | Publication date | Patent family member(s) | Publication date |
|---|---|---|---|
| JP 2021046361 A | 25-03-2021 | NONE | |
| US 2014106122 A1 | 17-04-2014 | CN 102869506 A | 09-01-2013 |
| | | JP 6056480 B2 | 11-01-2017 |
| | | JP 2017004012 A | 05-01-2017 |
| | | JP WO2011142433 A1 | 22-07-2013 |
| | | KR 20130103673 A | 24-09-2013 |
| | | TW 201202031 A | 16-01-2012 |
| | | US 2014106122 A1 | 17-04-2014 |
| | | US 2016116644 A1 | 28-04-2016 |
| | | WO 2011142433 A1 | 17-11-2011 |
| WO 2008022908 A1 | 28-02-2008 | CN 101548405 A | 30-09-2009 |
| | | EP 2057699 A1 | 13-05-2009 |
| | | ES 2704980 T3 | 21-03-2019 |
| | | JP 5457181 B2 | 02-04-2014 |
| | | JP 2010501652 A | 21-01-2010 |
| | | KR 20090042980 A | 04-05-2009 |
| | | US 2008050534 A1 | 28-02-2008 |
| | | WO 2008022908 A1 | 28-02-2008 |
| EP 2309519 A1 | 13-04-2011 | CN 102132358 A | 20-07-2011 |
| | | EP 2309519 A1 | 13-04-2011 |
| | | JP WO2010013660 A1 | 12-01-2012 |
| | | KR 20110055541 A | 25-05-2011 |
| | | TW 201012883 A | 01-04-2010 |
| | | US 2011135939 A1 | 09-06-2011 |
| | | WO 2010013660 A1 | 04-02-2010 |
| JP 2017222831 A | 21-12-2017 | JP 6919192 B2 | 18-08-2021 |
| | | JP 2017222831 A | 21-12-2017 |
| DE 102020114473 A1 | 10-12-2020 | CN 112071650 A | 11-12-2020 |
| | | DE 102020114473 A1 | 10-12-2020 |
| | | JP 2020202368 A | 17-12-2020 |
| WO 2015095758 A1 | 25-06-2015 | CN 106164663 A | 23-11-2016 |
| | | EP 3084411 A1 | 26-10-2016 |
| | | RU 2016124174 A | 24-01-2018 |
| | | US 2016291001 A1 | 06-10-2016 |
| | | WO 2015095758 A1 | 25-06-2015 |
| US 2019207113 A1 | 04-07-2019 | NONE | |
| WO 2021063956 A1 | 08-04-2021 | TW 202120581 A | 01-06-2021 |
| | | WO 2021063956 A1 | 08-04-2021 |

EPO FORM P0459

For more details about this annex : see Official Journal of the European Patent Office, No. 12/82

## ANNEX TO THE EUROPEAN SEARCH REPORT ON EUROPEAN PATENT APPLICATION NO. EP 21 18 1835

This annex lists the patent family members relating to the patent documents cited in the above-mentioned European search report. The members are as contained in the European Patent Office EDP file on
The European Patent Office is in no way liable for these particulars which are merely given for the purpose of information.

14-12-2021

| Patent document cited in search report | Publication date | Patent family member(s) | Publication date |
|---|---|---|---|
| | | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO A2012059215 A1
- KR 100945056 A
- WO 2021063956 A1

### Non-patent literature cited in the description

- **MCCULLOUGH et al.** A Simple Method to Prepare Head-to-Tail Coupled, Regioregular Poly(3-alkylthiophenes) Using Grignard Metathesis. *Adv. Mater.*, 1999, vol. 11, 250
- *CHEMICAL ABSTRACTS,* 552857-06-4
- *CHEMICAL ABSTRACTS,* 126213-50-1
- *CHEMICAL ABSTRACTS,* 384855-91-7
- *CHEMICAL ABSTRACTS,* 60506-81-2